# EUROPEAN PATENT APPLICATION

(11) **EP 4 773 128 A1**
(43) Date of publication of application: **08.07.2026**
(21) Application number: 24860353.2
(22) Date of filing: 26.08.2024
(51) Int. Cl.: G09G 3/3233, H10K 59/131, G09G 3/20

(54) **DISPLAY APPARATUS**

(30) Priority: 29.08.2023 KR 20230113979; 02.11.2023 KR 20230150286
(71) Applicant: Samsung Display Co., Ltd., Yongin-si, Gyeonggi-do 17113 (KR)
(72) Inventor: SHIM, Jong Sik, Yongin-si Gyeonggi-do 17113 (KR); KWAK, Won Kyu, Yongin-si Gyeonggi-do 17113 (KR); KANG, Chul Kyu, Yongin-si Gyeonggi-do 17113 (KR); KIM, Min Joo, Yongin-si Gyeonggi-do 17113 (KR); KIM, Su Jin, Yongin-si Gyeonggi-do 17113 (KR); EOM, Ki Myeong, Yongin-si Gyeonggi-do 17113 (KR); JEONG, Seon I, Yongin-si Gyeonggi-do 17113 (KR)
(74) Representative: Gulde & Partner
(86) International application number: PCT/KR2024/012710
(87) International publication number: WO 2025/048433

(57) **Abstract**

A display apparatus includes: a data line connected to a pixel arranged in a display area, wherein the data line extends in a first direction; a shielding line disposed over the data line in the display area, extending in the first direction, and overlapping the data line in a plan view; and a first voltage line connected to the pixel, extending in a second direction perpendicular to the first direction, disposed under the data line, and overlapping the data line in the plan view.

## Description

### Technical Field

One or more embodiments relate to a pixel and a display apparatus including the same.

### Background Art

A display apparatus has been used for various purposes. Also, as the display apparatus has become thinner and lighter, their range of use has widened.

As the display apparatus is used in various ways, various methods may be used to design the shapes of the display apparatus, and further, more and more functions may be combined or associated with the display apparatus.

### Disclosure of Invention

### Technical Problem

One or more embodiments include a display apparatus improved in display quality. However, these problems are merely examples and the scope of the disclosure is not limited thereto.

### Solution to Problem

According to one or more embodiments, a display apparatus includes: a data line connected to a pixel arranged in a display area, the data line extending in a first direction, a shielding line disposed over the data line in the display area, extending in the first direction, and overlapping the data line in a plan view, and a first voltage line connected to the pixel, extending in a second direction perpendicular to the first direction, disposed under the data line, and overlapping the data line in the plan view.

In an embodiment, the pixel may include a first capacitor including a first electrode and a second electrode disposed over the first electrode and overlapping the first electrode in the plan view, a first transistor connected to the first voltage line and the second electrode of the first capacitor, and a second transistor connected to the data line and a gate electrode of the first transistor, where the data line may be arranged in the same layer as the second electrode of the first capacitor, and a semiconductor layer of the first transistor may be arranged in the same layer as the first electrode of the first capacitor.

In an embodiment, a voltage supplied to the shielding line and a voltage supplied to the first electrode of the first capacitor may be different from each other.

In an embodiment, a voltage supplied to the shielding line and a voltage supplied to the first electrode of the first capacitor may be equal to each other.

In an embodiment, the first capacitor may further include a third electrode disposed under the first electrode, overlapping the first electrode in the plan view, and connected to the second electrode.

In an embodiment, the first voltage line may be arranged in the same layer as the third electrode of the first capacitor and connected to the first electrode of the first capacitor.

In an embodiment, the display apparatus may further include a vertical conductive line arranged in the same layer as the shielding line, overlapping the second electrode of the first capacitor in the plan view, and extending in the first direction.

In an embodiment, the vertical conductive line may be configured to supply a constant voltage to the pixel and connected to a horizontal conductive line extending in the second direction.

In an embodiment, the horizontal conductive line may include the first voltage line.

In an embodiment, the pixel further may include a second capacitor connected to the second electrode of the first capacitor and a light emitting element, where the light emitting element may include a first electrode connected to the first transistor and a second electrode facing the first electrode, and the second capacitor may be connected to the second electrode of the light emitting element.

In an embodiment, the display apparatus may further include a second voltage line extending in the second direction and connected to the first electrode of the first capacitor.

In an embodiment, the display apparatus may further include a vertical conductive line arranged in the same layer as the shielding line, overlapping the first electrode of the first capacitor in the plan view, and extending in the first direction.

In an embodiment, the vertical conductive line may be configured to supply a constant voltage to the pixel and connected to a horizontal conductive line extending in the second direction.

In an embodiment, the horizontal conductive line may include the second voltage line.

In an embodiment, the display apparatus may further include a voltage supply line arranged in a non-display area outside the display area, connected to the shielding line, and configured to supply a shielding voltage to the shielding line.

According to one or more embodiments, a display apparatus includes a first pixel circuit arranged in a first circuit area, and a second pixel circuit arranged in a second circuit area adjacent to the first circuit area in a first direction, where each of the first pixel circuit and the second pixel circuit is connected to a light-emitting diode, and each of the first pixel circuit and the second pixel circuit includes a data line extending in a second direction perpendicular to the first direction, a shielding line disposed over the data line, extending in the second direction, and overlapping the data line in the plan view, a first voltage line extending in the first direction, disposed under the data line, and partially overlapping the data line in the plan view, a capacitor including a first electrode and a second electrode disposed over the first electrode and overlapping the first electrode in the plan view, a first transistor connected to the first voltage line and the second electrode of the capacitor, a second transistor connected to the data line and a gate electrode of the first transistor, a third transistor connected to the gate electrode of the first transistor and a second voltage line extending in the first direction, a fourth transistor connected to a first electrode of the light-emitting diode and a third voltage line extending in the first direction, and a conductive line arranged in the same layer as the shielding line, overlapping the second electrode of the capacitor in the plan view, and extending in the second direction. The light-emitting diode connected to the first pixel circuit emits light in a first color, the light-emitting diode connected to the second pixel circuit emits light in a second color, the conductive line of the first pixel circuit is connected to one of the first voltage line, the second voltage line, the third voltage line, and a fourth voltage line connected to a second electrode of the light-emitting diode, and the conductive line of the second pixel circuit is connected to one of the second voltage line, the third voltage line, and the fourth voltage line, excluding the first voltage line.

In an embodiment, a voltage supplied to the shielding line and a voltage supplied to the first electrode of the capacitor may be different from each other.

In an embodiment, a voltage supplied to the shielding line and a voltage supplied to the first electrode of the capacitor may be equal to each other.

In an embodiment, the capacitor may further include a third electrode disposed under the first electrode, overlapping the first electrode in the plan view, and connected to the second electrode.

In an embodiment, the first voltage line may be arranged in the same layer as the third electrode of the capacitor and connected to the first electrode of the capacitor.

In an embodiment, the second voltage line may be arranged in the same layer as the third electrode of the capacitor and connected to the first electrode of the capacitor.

### Advantageous Effects of Invention

According to embodiments, a display apparatus improved in display quality may be provided. However, the scope of the disclosure is not limited to these effects.

### Brief Description of Drawings

FIGS. 1A, 1B, and 2 are diagrams schematically illustrating a display apparatus according to an embodiment.
FIG. 3 is an equivalent circuit diagram of a pixel according to an embodiment.
FIGS. 4A to 4C are diagrams schematically illustrating the shielding of a data line according to an embodiment.
FIGS. 5A to 5D are diagrams schematically illustrating a shielding line according to an embodiment.
FIG. 6 is a layout diagram schematically illustrating the position of transistors and capacitors of the pixel illustrated in FIG. 3.
FIGS. 7 to 16 are layout diagrams schematically illustrating the components of the pixel of FIG. 3 on a layer-by-layer basis.
FIG. 17 is a cross-sectional view of the pixel taken along line I-I' of FIG. 6.
FIG. 18 is a cross-sectional view of the pixel taken along line II-II' of FIG. 6.
FIG. 19 is a diagram illustrating the arrangement of a data line and a signal line according to a comparative example.
FIG. 20 is a diagram schematically illustrating the arrangement of vertical conductive lines according to an embodiment.
FIG. 21 illustrates an example of a cross-section of a second pixel according to an embodiment.
FIGS. 22 to 26 illustrate equivalent circuits of a pixel according to embodiments.
FIGS. 27 to 32 are equivalent circuit diagrams of a pixel according to embodiments.
FIG. 33 is an equivalent circuit diagram of a pixel according to an embodiment.
FIG. 34 is a layout diagram schematically illustrating the position of transistors and capacitors of the pixel illustrated in FIG. 33.
FIGS. 35 to 41 are layout diagrams schematically illustrating the components of the pixel of FIG. 33 on a layer-by-layer basis.
FIG. 42 is a cross-sectional view of the pixel taken along line III-III' of FIG. 34.
FIG. 43 is a diagram illustrating the arrangement of a data line and a signal line according to a comparative example.
FIGS. 44 to 49 illustrate equivalent circuits of a pixel according to embodiments.
FIGS. 50A to 51B are cross-sectional views illustrating the structure of a display element according to embodiments.
FIG. 52 is a cross-sectional view illustrating the structure of a pixel of a display apparatus according to an embodiment.

### Best Mode for Carrying out the Invention

According to one or more embodiments, a display apparatus includes: a data line connected to a pixel arranged in a display area, the data line extending in a first direction, a shielding line disposed over the data line in the display area, extending in the first direction, and overlapping the data line in a plan view, and a first voltage line connected to the pixel, extending in a second direction perpendicular to the first direction, disposed under the data line, and overlapping the data line in the plan view.

### Mode for the Invention

The disclosure may include various embodiments and modifications, and particular embodiments thereof are illustrated in the drawings and will be described herein in detail. The effects and features of the disclosure and the accomplishing methods thereof will become apparent from the embodiments described below in detail with reference to the accompanying drawings. However, the disclosure is not limited to the embodiments described below, and may be embodied in various modes.

It will be understood that although terms such as "first" and "second" may be used herein to describe various elements, these elements should not be limited by these terms and these terms are only used to distinguish one element from another element.

As used herein, the singular forms "a," "an," and "the" are intended to include the plural forms as well, unless the context clearly indicates otherwise.

Also, it will be understood that the terms "comprise," "include," and "have" used herein specify the presence of stated features or elements, but do not preclude the presence or addition of one or more other features or elements.

As used herein, "A and/or B" represents the case of A, B, or A and B. Also, "at least one of A and B" represents the case of A, B, or A and B.

In the following embodiments, when X and Y are connected to each other, X and Y may be functionally connected to each other, X and Y may be electrically connected to each other, or X and Y may be physically connected to each other. Also, when X and Y are connected to each other, X and Y may be directly connected to each other or X and Y may be indirectly connected to each other with one or more other elements therebetween. Here, X and Y may be elements (e.g., apparatuses, devices, circuits, lines, electrodes, terminals, films, layers, or areas). For example, when X and Y are electrically connected to each other, X and Y may be electrically connected to each other directly, or X and Y may be electrically connected to each other indirectly with one or more other elements therebetween. When X and Y are electrically connected to each other indirectly, one or more devices (e.g., switches, transistors, capacitors, inductors, resistors, or diodes) enabling the electrical connection between X and Y may be connected between X and Y. Thus, the disclosure is not limited to a certain connection relationship, for example, a connection relationship indicated in the drawings or the detailed description, and may also include anything other than the connection relationship indicated in the drawings or the detailed description.

In the following embodiments, "ON" used in connection with a device state may refer to an activated state of the device, and "OFF" may refer to a deactivated state of the device. "ON" used in connection with a signal received by a device may refer to a signal activating the device, and "OFF" may refer to a signal deactivating the device. The device may be activated by a high-level voltage or a low-level voltage. For example, a P-channel transistor (P-type transistor) may be activated by a low-level voltage, and an N-channel transistor (N-type transistor) may be activated by a high-level voltage. Thus, it should be understood that "ON" voltages for the P-type transistor and the N-type transistor have opposite (low versus high) voltage levels.

Also, herein, the x direction, the y direction, and the z direction are not limited to the directions along three axes of the rectangular coordinate system and may be interpreted in a broader sense. For example, the x direction, the y direction, and the z direction may be perpendicular to one another or may represent different directions that are not perpendicular to one another.

A display apparatus according to embodiments may be an apparatus displaying a moving image or a still image and may be used as a display screen of various products such as televisions, notebook computers, monitors, billboards, and Internet of Things ("IoT") as well as portable electronic apparatuses such as mobile phones, smart phones, tablet personal computers ("PCs"), mobile communication terminals, electronic notebooks, electronic books, portable multimedia players ("PMPs"), navigation, and Ultra Mobile PCs ("UMPCs"). Also, the display apparatus according to an embodiment may be used in wearable devices such as smart watches, watch phones, glasses-type displays, and head-mounted displays ("HMDs"). Also, the display apparatus according to an embodiment may be used as a center information display ("CID") arranged at a vehicle's instrument panel or a vehicle's center fascia or dashboard, a room mirror display replacing a vehicle's side mirror, or a display arranged at a rear side of a vehicle's front seat as an entertainment for a vehicle's rear seat. Also, the display apparatus may be a flexible apparatus.

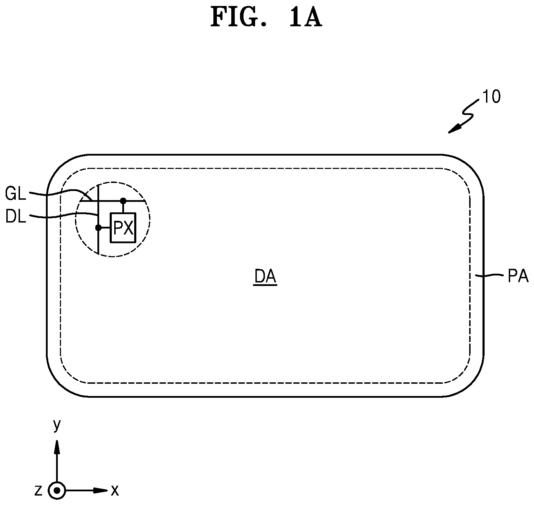

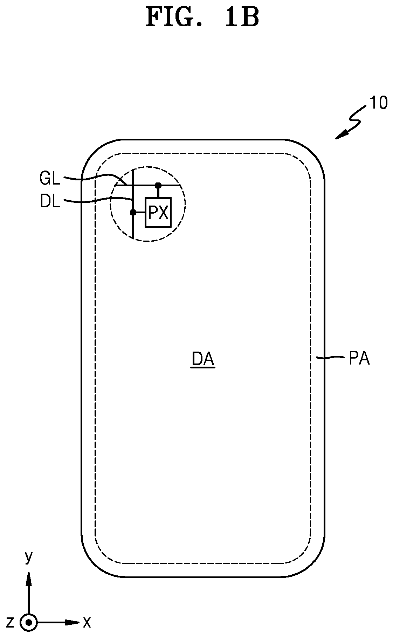

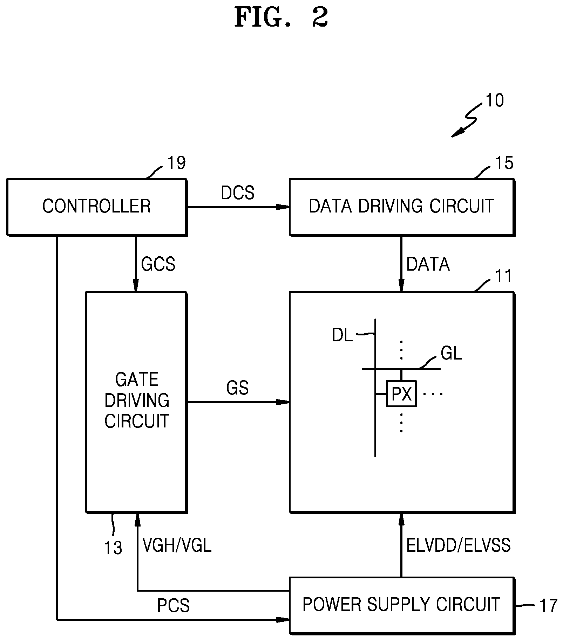

FIGS. 1A, 1B, and 2 are diagrams schematically illustrating a display apparatus according to an embodiment.

Referring to FIGS. 1A and 1B, a display apparatus 10 may include a display area DA displaying an image and a peripheral area PA outside the display area DA. The display area DA may be entirely surrounded by the peripheral area PA.

In the plan view, the display area DA may have a rectangular shape. In other embodiments, the display area DA may have a polygonal shape such as a triangular, pentagonal, or hexagonal shape, a circular shape, an elliptical shape, an atypical shape, or the like. A corner of the edge of the display area DA may have a round shape. In an embodiment, as illustrated in FIG. 1A, the display apparatus 10 may include a display area DA having a shape in which the length in the x direction is greater than the length in the y direction. In another embodiment, as illustrated in FIG. 1B, the display apparatus 10 may include a display area DA having a shape in which the length in the y direction is greater than the length in the x direction.

Referring to FIG. 2, the display apparatus 10 according to an embodiment may include a pixel area 11, a gate driving circuit 13, a data driving circuit 15, a power supply circuit 17, and a controller 19.

The pixel area 11 may be provided in the display area DA. Various conductive lines for transmitting electrical signals to be applied to the display area DA, external circuits electrically connected to pixel circuits, and/or pads to which a printed circuit board or a driver IC chip is attached may be located in the peripheral area PA. For example, the gate driving circuit 13, the data driving circuit 15, the power supply circuit 17, and the controller 19 may be provided in the peripheral area PA.

As illustrated in FIG. 2, a plurality of gate lines GL, a plurality of data lines DL, and a plurality of pixels PX connected thereto may be arranged in the display area DA. The plurality of pixels PX may be arranged in various forms such as stripe arrangement, pentile arrangement, diamond arrangement, and mosaic arrangement to implement an image. Each pixel PX may include an organic light-emitting diode OLED as a display element (referred to as "light emitting element"), and the organic light-emitting diode OLED may be connected to a pixel circuit. The pixel PX may emit, for example, red, green, blue, or white light from the organic light-emitting diode OLED. Each pixel PX may be connected to at least one corresponding gate line among the plurality of gate lines GL and a corresponding data line among the plurality of data lines DL.

Each of the gate lines GL may extend in the x direction (row direction) to be connected to the pixels PX located in the same row. The gate line GL may be configured to transmit a gate signal to the pixels PX in the same row. Each of the data lines DL may extend in the y direction (column direction) to be connected to the pixels PX located in the same column. Each of the data lines DL may be configured to transmit a data signal DATA to each of the pixels PX in the same column in synchronization with a gate signal.

In an embodiment, the peripheral area PA may be a non-display area in which pixels PX are not arranged. In another embodiment, a plurality of pixels PX may be arranged in at least one corner of the peripheral area PA to overlap the gate driving circuit 13 in a plan view. Accordingly, a dead area may be reduced and the display area DA may be extended.

The gate driving circuit 13 may be connected to a plurality of gate lines GL, may generate gate signals in response to a driving control signal GCS from the controller 19, and may sequentially supply the gate signals to the gate lines GL. The gate line GL may be connected to the gate of the transistor included in the pixel PX. A gate signal GS may be a gate control signal for controlling turn-on and turn-off of the transistor whose gate is connected to the gate line GL. The gate signal GS may be a signal including a gate-on voltage at which the transistor may be turned on and a gate-off voltage at which the transistor may be turned off. In an embodiment, the gate-on voltage may be a high-level voltage (first-level voltage) or a low-level voltage (second-level voltage).

FIGS. 1A, 1B, and 2 illustrate that the pixel PX is connected to one gate line GL; however, this is merely an example and the pixel PX may be connected to two or more gate lines and the gate driving circuit 13 may supply, to the two or more gate lines, two or more gate signals with different timings when an on voltage is applied.

The data driving circuit 15 may be connected to a plurality of data lines DL and may supply a data signal DATA to the data lines DL in response to a driving control signal DCS from the controller 19. The data signal DATA supplied to the data line DL may be supplied to the pixel PX to which the gate signal GS is supplied. The data driving circuit 15 may convert input image data with gradation input from the controller 19, into a data signal DATA in the form of a voltage or current.

The power supply circuit 17 may generate signals (voltage and current) for driving the pixel PX, in response to a driving control signal PCS from the controller 19. The power supply circuit 17 may generate a first driving voltage ELVDD and a second driving voltage ELVSS and supply the same to the pixels PX. The first driving voltage ELVDD may be a high-level voltage provided to a first terminal of a driving transistor connected to a first electrode (pixel electrode or anode) of the display element included in the pixel PX. The second driving voltage ELVSS may be a low-level voltage provided to a second electrode (opposite electrode or cathode) of the display element included in the pixel PX. The power supply circuit 17 may generate a high-level high voltage VGH and a low-level low voltage VGL and supply the same to the gate driving circuit 13.

The controller 19 may generate driving control signals GCS, DCS, and PCS based on signals input from outside and supply the same to the gate driving circuit 13, the data driving circuit 15, and the power supply circuit 17. The driving control signal GCS output to the gate driving circuit 13 may include a gate start signal and a plurality of clock signals. The driving control signal DCS output to the data driving circuit 15 may include a source start signal and a plurality of clock signals.

The display apparatus 10 may include a display panel, and the display panel may include a substrate. Pixels PX may be arranged in the display area DA of the substrate. A portion or all of the gate driving circuit 13 may be directly formed in the peripheral area PA of the substrate in the process of forming transistors constituting a pixel circuit in the display area DA of the substrate. Each of the data driving circuit 15, the power supply circuit 17, and the controller 19 may be formed in the form of a separate integrated circuit chip or a single integrated circuit chip and disposed over a flexible printed circuit board ("FPCB") electrically connected to a pad arranged on one side of the substrate. In other embodiments, the data driving circuit 15, the power supply circuit 17, and the controller 19 may be directly disposed over the substrate by using a chip-on-glass ("COG") or chip-on-plastic ("COP") method.

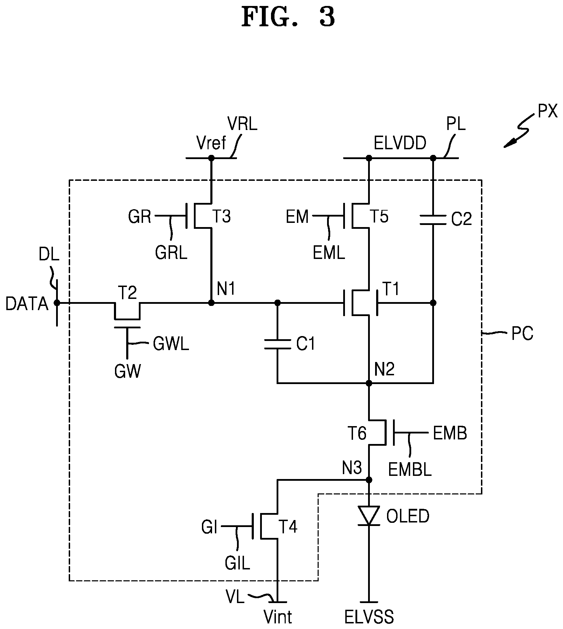

FIG. 3 is an equivalent circuit diagram of a pixel according to an embodiment.

Referring to FIG. 3, a pixel PX may include a pixel circuit PC and an organic light-emitting diode OLED as a display element connected to the pixel circuit PC.

The pixel PX may be connected to a first gate line GWL configured to transmit a first gate signal GW, a second gate line GIL configured to transmit a second gate signal GI, a third gate line GRL configured to transmit a third gate signal GR, a fourth gate line EML configured to transmit a fourth gate signal EM, a fifth gate line EMBL configured to transmit a fifth gate signal EMB, and a data line DL configured to transmit a data signal DATA. Because the light emission of the pixel PX is controlled by the fourth gate signal EM and the fifth gate signal EMB, the fourth gate signal EM and the fifth gate signal EMB may be referred to as an emission control signal and the fourth gate line EML and the fifth gate line EMBL may be referred to as an emission control line. Also, the pixel PX may be connected to a driving voltage line PL configured to transmit a first driving voltage ELVDD, a reference voltage line VRL configured to transmit a reference voltage Vref, and an initialization voltage line VL configured to transmit an initialization voltage Vint.

In an embodiment, a plurality of transistors included in the pixel circuit PC may be N-type oxide thin film transistors. The oxide thin film transistor may include a semiconductor layer including an amorphous or crystalline oxide semiconductor. The oxide semiconductor may include a Zn oxide-based material such as a Zn oxide, an In-Zn oxide, or a Ga-In-Zn oxide. In some embodiments, the oxide semiconductor may be an In-Ga-Zn-O ("IGZO") semiconductor. In some embodiments, the oxide semiconductor may be an In-Sn-Ga-Zn-O ("ITGZO") semiconductor. In an embodiment, the oxide thin film transistor may be a low-temperature polycrystalline oxide ("LTPO") thin film transistor. However, this is merely an example and the N-type transistors are not limited thereto. For example, the semiconductor layer included in the N-type transistor may include an inorganic semiconductor (e.g., amorphous silicon or polysilicon) or an organic semiconductor.

The pixel circuit PC may include first to sixth transistors T1 to T6 and first and second capacitors C1 and C2. The first transistor T1 may be a driving transistor for outputting a driving current corresponding to the data signal DATA, and the second to sixth transistors T2 to T6 may be switching transistors configured to transmit signals. A first terminal (first electrode) and a second terminal (second electrode) of each of the first to sixth transistors T1 to T6 may be a source or a drain depending on the voltages of the first terminal and the second terminal. For example, depending on the voltages of the first terminal and the second terminal, the first terminal may be a drain and the second terminal may be a source, or the first terminal may be a source and the second terminal may be a drain. Hereinafter, a node to which a first gate of the first transistor T1 is connected may be defined as a first node N1, and a node to which a second terminal of the first transistor T1 is connected may be defined as a second node N2.

The first transistor T1 may be connected to the driving voltage line PL and the organic light-emitting diode OLED. The first transistor T1 may be connected between the fifth transistor T5 and the sixth transistor T6. The first transistor T1 may include a gate, a first terminal, and a second terminal connected to the second node N2. The first transistor T1 may be a dual-gate transistor. The first transistor T1 may include a first gate connected to the first node N1. The first transistor T1 may further include a second gate connected to the second terminal thereof. The first gate and the second gate of the first transistor T1 may be arranged on different layers from each other to face each other. For example, the first gate and the second gate of the first transistor T1 may be located to face each other with a semiconductor layer therebetween. Hereinafter, the gate (or gate electrode) of the first transistor T1 may refer to the first gate for receiving the data signal DATA as a gate signal.

The first gate of the first transistor T1 may be connected to the second terminal of the second transistor T2, the first terminal of the third transistor T3, and the first capacitor C1. The second gate of the first transistor T1 may be connected to the first terminal of the sixth transistor T6, the first capacitor C1, and the second capacitor C2. The first terminal of the first transistor T1 may be connected to the driving voltage line PL via the fifth transistor T5, and the second terminal thereof may be connected to the pixel electrode of the organic light-emitting diode OLED via the sixth transistor T6. The first terminal of the first transistor T1 may be connected to the second terminal of the fifth transistor T5. The second terminal of the first transistor T1 may be connected to the first terminal of the sixth transistor T6, the first capacitor C1, and the second capacitor C2. The first transistor T1 may receive a data signal DATA according to a switching operation of the second transistor T2 and output a driving current to the data signal DATA.

The second transistor T2 may be connected to the data line DL and the first gate of the first transistor T1. The second transistor T2 may include a gate connected to the first gate line GWL, a first terminal connected to the data line DL, and a second terminal connected to the first node N1. The second terminal of the second transistor T2 may be connected to the first gate of the first transistor T1, the first terminal of the third transistor T3, and the first capacitor C1. The second transistor T2 may be turned on by the first gate signal GW received from the first gate line GWL, to electrically connect the data line DL with the first node N1 and transmit the data signal DATA received through the data line DL, to the first node N1.

The third transistor T3 may be connected to the first gate of the first transistor T1 and the reference voltage line VRL. The third transistor T3 may include a gate connected to the third gate line GRL, a first terminal connected to the first node N1, and a second terminal connected to the reference voltage line VRL. The first terminal of the third transistor T3 may be connected to the first gate of the first transistor T1, the second terminal of the second transistor T2, and the first capacitor C1. The third transistor T3 may be turned on by the third gate signal GR received from the third gate line GRL, to transmit the reference voltage Vref received through the reference voltage line VRL, to the first node N1.

The fourth transistor T4 may be connected to the sixth transistor T6 and the initialization voltage line VL. The fourth transistor T4 may be connected between the organic light-emitting diode OLED and the initialization voltage line VL. The fourth transistor T4 may include a gate connected to the second gate line GIL, a first terminal connected to a third node N3, and a second terminal connected to the initialization voltage line VL. The first terminal of the fourth transistor T4 may be connected to the second terminal of the sixth transistor T6 and the pixel electrode of the organic light-emitting diode OLED. The fourth transistor T4 may be turned on by the second gate signal GI received from the second gate line GIL, to transmit the initialization voltage Vint received through the initialization voltage line VL, to the third node N3.

The fifth transistor T5 may be connected to the driving voltage line PL and the first node N1. The fifth transistor T5 may include a gate connected to the fourth gate line EML, a first terminal connected to the driving voltage line PL, and a second terminal connected to the first terminal of the first transistor T1. The fifth transistor T5 may be turned on or off according to the fourth gate signal EM received from the fourth gate line EML.

The sixth transistor T6 may be connected to the first transistor T1 and the organic light-emitting diode OLED. The sixth transistor T6 may be connected between the second node N2 and the third node N3. The sixth transistor T6 may include a gate connected to the fifth gate line EMBL, a first terminal connected to the second node N2, and a second terminal connected to the third node N3. The first terminal of the sixth transistor T6 may be connected to the second terminal of the first transistor T1, the first capacitor C1, and the second capacitor C2. The second terminal of the sixth transistor T6 may be connected to the first terminal of the fourth transistor T4 and the pixel electrode of the organic light-emitting diode OLED. The sixth transistor T6 may be turned on or off according to the fifth gate signal EMB received from the fifth gate line EMBL.

The first capacitor C1 may be connected between the first gate of the first transistor T1 and the second terminal of the first transistor T1. A first electrode of the first capacitor C1 may be connected to the first node N1, and a second electrode of the first capacitor C1 may be connected to the second node N2. The first electrode of the first capacitor C1 may be connected to the first gate of the first transistor T1, the second terminal of the second transistor T2, and the first terminal of the third transistor T3. A second electrode of the first capacitor C1 may be connected to the second terminal and the second gate of the first transistor T1, the second electrode of the second capacitor C2, and the first terminal of the sixth transistor T6. The first capacitor C1 may be a storage capacitor and may store a threshold voltage of the first transistor T1 and a voltage corresponding to the data signal DATA.

The first transistor T1 may be turned on when the third transistor T3 and the fifth transistor T5 are turned on together. When the voltage of the second terminal of the first transistor T1 reaches the difference (Vref-Vth) between the reference voltage Vref and the threshold voltage (Vth) of the first transistor T1, the first transistor T1 may be turned off and a voltage corresponding to the threshold voltage (Vth) of the first transistor T1 may be stored in the first capacitor C1 and thus the threshold voltage (Vth) of the first transistor T1 may be compensated.

The second capacitor C2 may be connected between the driving voltage line PL and the second node N2. A first electrode of the second capacitor C2 may be connected to the driving voltage line PL. A second electrode of the second capacitor C2 may be connected to the second terminal and the second gate of the first transistor T1, the second electrode of the first capacitor C1, and the first terminal of the sixth transistor T6. The second capacitor C2 may be configured to maintain the voltage stored in the first capacitor C1.

The capacitance of each of the first capacitor C1 and the second capacitor C2 may vary depending on the color of light emitted by the pixel PX.

The organic light-emitting diode OLED may be connected to the first transistor T1 through the sixth transistor T6. The organic light-emitting diode OLED may include a pixel electrode (anode) connected to the third node N3 and an opposite electrode (cathode) facing the pixel electrode, and the opposite electrode may receive a second driving voltage (a common voltage) ELVSS. The opposite electrode may be a common electrode common to a plurality of pixels PX. The driving current output by the first transistor T1 may flow through the organic light-emitting diode OLED due to the turned-on fifth transistor T5 and the turned-on sixth transistor T6, and the organic light-emitting diode OLED may emit light with a brightness corresponding to the driving current.

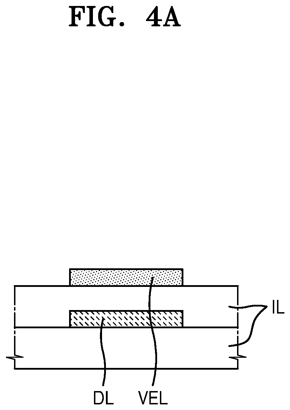

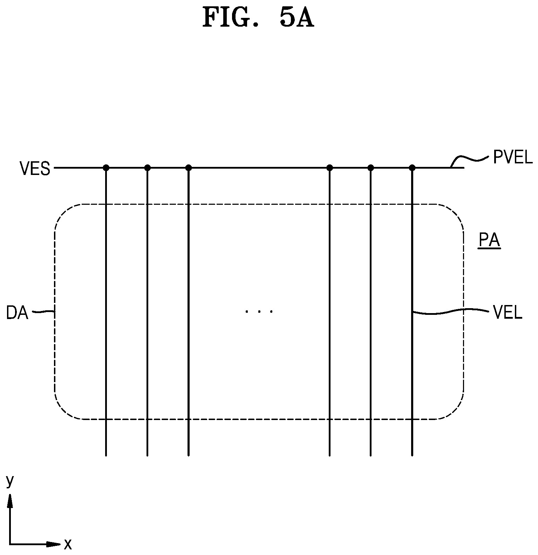

FIGS. 4A to 4C are diagrams schematically illustrating the shielding of a data line according to an embodiment. FIGS. 5A to 5D are diagrams schematically illustrating a shielding line according to an embodiment.

In an embodiment, a shielding line VEL overlapping a data line DL in a plan view may be provided over and/or under the data line DL. At least one insulating layer IL may be arranged between the data line DL and the shielding line VEL. Accordingly, the influence of a coupling between the data line DL and at least one signal line due to a change in the data signal DATA on a gate-source voltage change of the first transistor T1 as a driving transistor may be minimized.

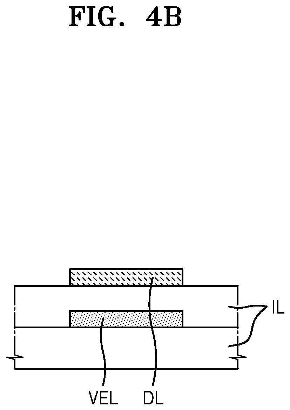

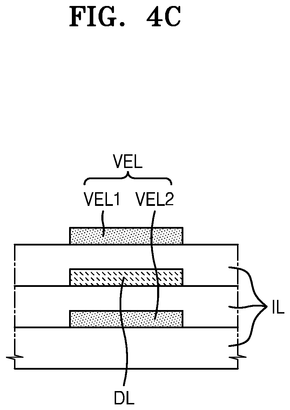

In an embodiment, as illustrated in FIG. 4A, a shielding line VEL overlapping a data line DL in a plan view may be disposed over the data line DL. In an embodiment, as illustrated in FIG. 4B, a shielding line VEL overlapping a data line DL in a plan view may be disposed under the data line DL. In an embodiment, as illustrated in FIG. 4C, a shielding line VEL may include a first shielding line VEL1 and a second shielding line VEL2, the first shielding line VEL1 may be disposed over a data line DL to overlap the data line DL, and the second shielding line VEL2 may be disposed under the data line DL to overlap the data line DL in a plan view.

As illustrated in FIGS. 5A to 5D, a shielding line VEL may extend in the y direction in the display area DA of the substrate and may be a straight line having a stripe shape. In an embodiment, each shielding line VEL may be arranged to overlap a data line DL in a plan view in each pixel column of the display area DA. In an embodiment, shielding lines VEL may be arranged at certain intervals to overlap data lines DL in a plan view in some of the pixel columns of the display area DA. The shielding line VEL may be a conductive line that is not electrically connected to the pixels PX in the display area DA.

In the peripheral area PA of the substrate, the shielding line VEL may be electrically connected to a shielding voltage supply line PVEL arranged in the peripheral area PA, to receive a shielding voltage VES, which is a constant voltage, from the shielding voltage supply line PVEL.

In an embodiment, as illustrated in FIG. 5A, the shielding voltage supply line PVEL may be arranged extending in the x direction on the upper side of the display area DA and may be electrically connected to one end of each of a plurality of shielding lines VEL extending from the display area DA.

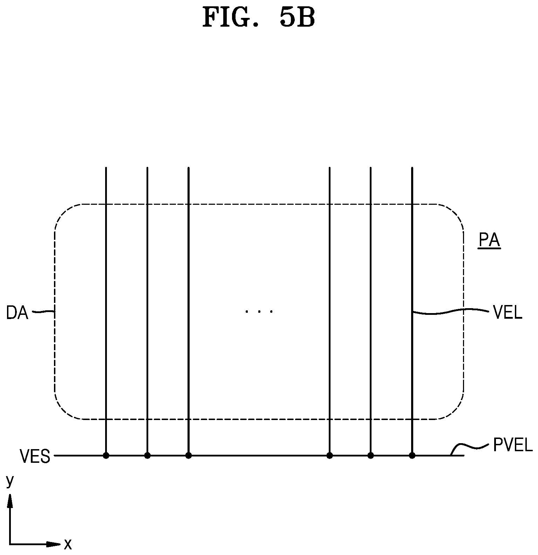

In an embodiment, as illustrated in FIG. 5B, the shielding voltage supply line PVEL may be arranged extending in the x direction on the lower side of the display area DA and may be electrically connected to one end of each of a plurality of shielding lines VEL extending from the display area DA.

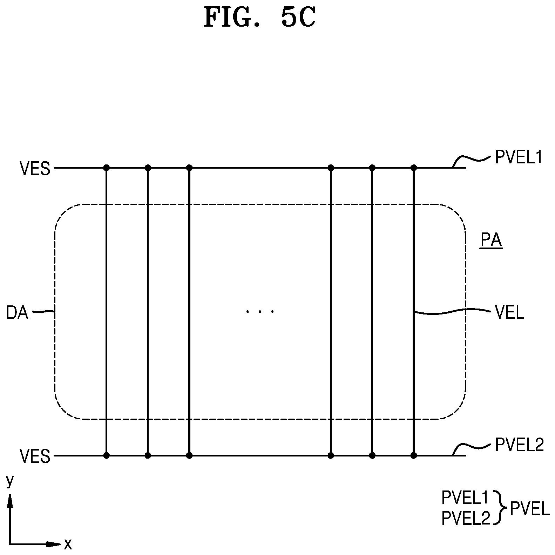

In an embodiment, as illustrated in FIG. 5C, the shielding voltage supply line PVEL may include a first voltage supply line PVEL1 extending in the x direction on the upper side of the display area DA and a second voltage supply line PVEL2 extending in the x direction on the lower side of the display area DA. One end of each of a plurality of shielding lines VEL may be electrically connected to the first voltage supply line PVEL1, and the other end of each of the plurality of shielding lines VEL may be electrically connected to the second voltage supply line PVEL2.

In an embodiment, the shielding voltage VES supplied by the shielding voltage supply line PVEL may be a separate voltage different from a plurality of voltages (e.g., the first driving voltage ELVDD, the reference voltage Vref, and the initialization voltage Vint) supplied to the pixel PX.

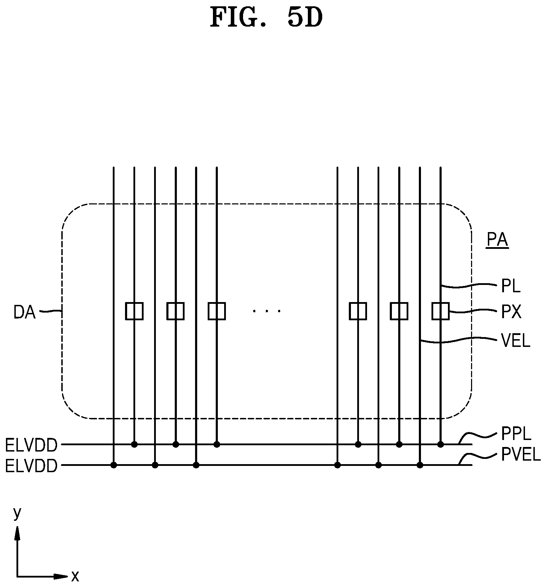

In an embodiment, the shielding voltage VES supplied by the shielding voltage supply line PVEL may be one of a plurality of voltages (e.g., the first driving voltage ELVDD, the reference voltage Vref, and the initialization voltage Vint) supplied to the pixel PX. The shielding line VEL may not be electrically connected to the driving voltage line PL, the reference voltage line VRL, and the initialization voltage line VL that are arranged in the display area DA and electrically connected to the pixels PX. For example, as illustrated in FIG. 5D, a shielding voltage supply line PVEL may be configured to supply the first driving voltage ELVDD to a shielding line VEL, and a driving voltage supply line PPL may be configured to supply the first driving voltage ELVDD to a driving voltage line PL. The driving voltage lines PL may be electrically connected to the pixels PX arranged in the display area DA. The shielding lines VEL may be arranged in the display area DA but may not be electrically connected to the pixels PX arranged in the display area DA.

In an embodiment, the shielding lines VEL may receive one of constant voltages (e.g., a high voltage VGH, a low voltage VGL, and a ground voltage) supplied to a peripheral circuit (e.g., a gate driving circuit) supplying electrical signals to the pixel PX.

Even when a change in the data signal DATA causes a voltage change of the shielding line VEL due to a coupling of a capacitor formed between the data line DL and the shielding line VEL, because the shielding line VEL is not electrically connection to the pixel PX, a voltage change at the terminals of other devices of the pixel PX may be prevented (minimized).

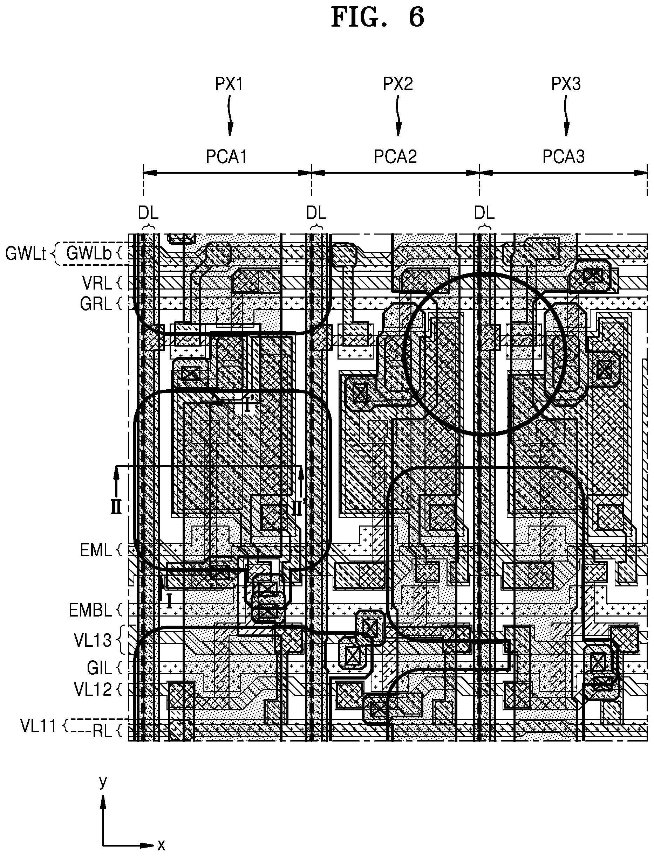

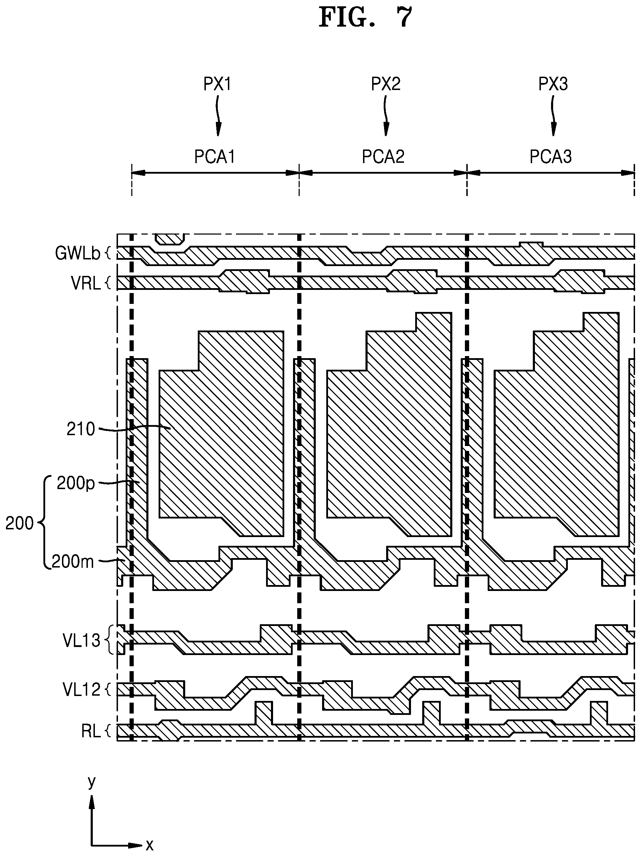

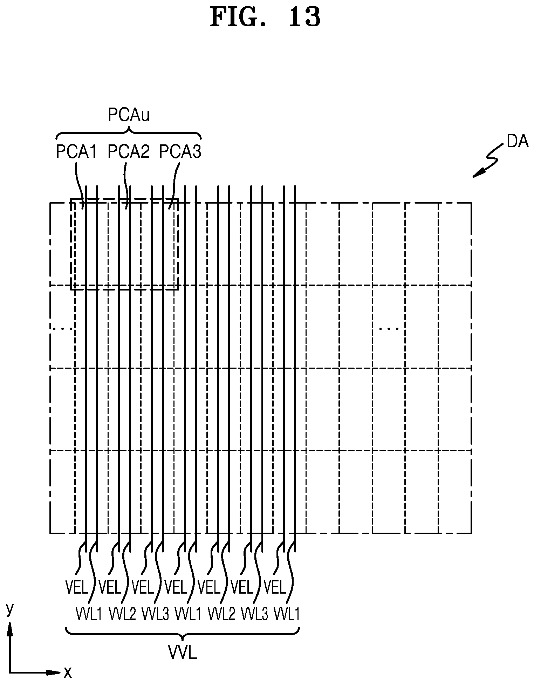

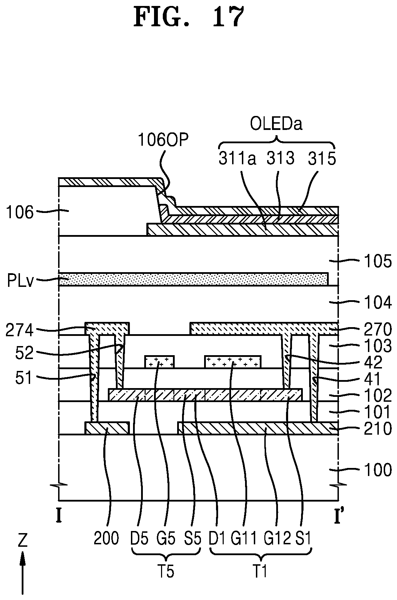

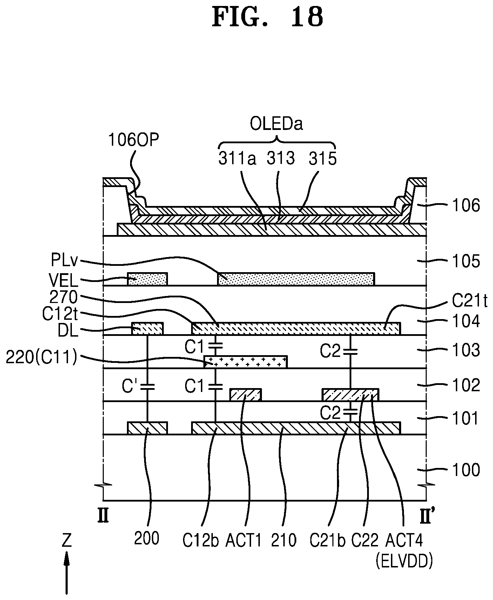

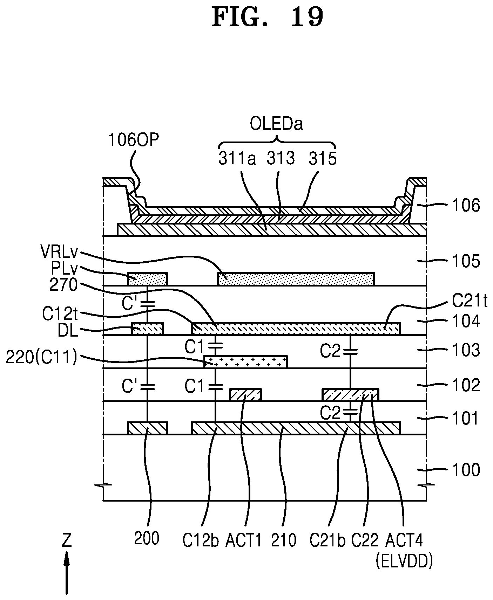

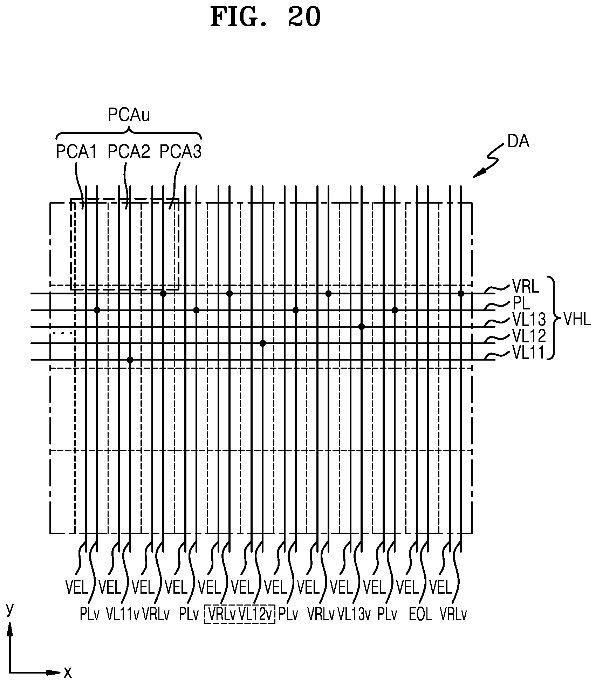

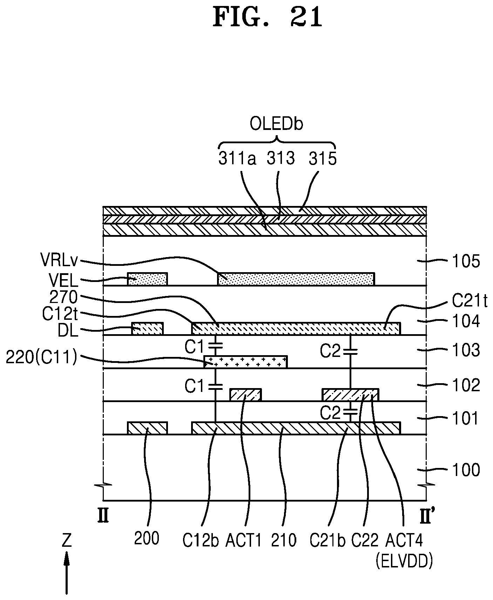

FIG. 6 is a layout diagram schematically illustrating the position of transistors and capacitors of the pixel illustrated in FIG. 3. FIGS. 7 to 16 are layout diagrams schematically illustrating the components of the pixel of FIG. 3 on a layer-by-layer basis. FIGS. 13 to 15 are diagrams schematically illustrating the arrangement of vertical conductive lines according to an embodiment. FIG. 17 is a cross-sectional view of the pixel taken along line I-I' of FIG. 6. FIG. 18 is a cross-sectional view of the pixel taken along line II-II' of FIG. 6. FIG. 19 is a diagram illustrating the arrangement of a data line and a signal line according to a comparative example. FIG. 20 is a diagram schematically illustrating the arrangement of vertical conductive lines according to an embodiment. FIG. 21 illustrates an example of a cross-section of a second pixel according to an embodiment.

A plurality of pixels PX arranged in the display area DA may include a first pixel PX1 emitting light in a first color, a second pixel PX2 emitting light in a second color, and a third pixel PX3 emitting light in a third color. For example, the first pixel PX1 may be a red pixel, the second pixel PX2 may be a green pixel, and the third pixel PX3 may be a blue pixel. The first pixel PX1, the second pixel PX2, and the third pixel PX3 may be repeatedly arranged according to a certain pattern in the x direction and the y direction. Each of the first pixel PX1, the second pixel PX2, and the third pixel PX3 may include a pixel circuit and an organic light-emitting diode OLED as a display element electrically connected to the pixel circuit.

The display area DA defined in a substrate 100 may include a plurality of circuit areas in which rows (pixel rows) and columns (pixel columns) intersect each other and pixel circuits are arranged. In an embodiment, a unit circuit area including two or more circuit areas adjacent to each other in the x direction may be defined, and a unit pixel may be defined by the pixels arranged in the circuit areas constituting the unit circuit area. For example, a unit circuit area PCAu may include three circuit areas, that is, a first circuit area PCA1, a second circuit area PCA2, and a third circuit area PCA3 adjacent in the x direction, and a unit pixel may include a first pixel PX1, a second pixel PX2, and a third pixel PX3. The first circuit area PCA1 may be an area in which a pixel circuit of the first pixel PX1 is arranged. The second circuit area PCA2 may be an area in which a pixel circuit of the second pixel PX2 is arranged. The third circuit area PCA3 may be an area in which a pixel circuit of the third pixel PX3 is arranged.

In FIG. 6, each of the pixel circuits arranged in the first circuit area PCA1, the second circuit area PCA2, and the third circuit area PCA3 may correspond to the pixel circuit PC of the pixel illustrated in FIG. 3.

In an embodiment, by considering the light emission characteristics of the first pixel PX1, the second pixel PX2, and the third pixel PX3, different initialization voltages Vint may be supplied to the first pixel PX1, the second pixel PX2, and the third pixel PX1. For example, a pixel circuit PC of the first pixel PX1 may be connected to a 1st-1 initialization voltage line VL11, a pixel circuit PC of the second pixel PX2 may be connected to a 1st-2 initialization voltage line VL12, and a pixel circuit PC of the third pixel PX3 may be connected to a 1st-3 initialization voltage line VL13. An initialization voltage supplied to the 1st-1 initialization voltage line VL11, an initialization voltage supplied to the 1st-2 initialization voltage line VL12, and an initialization voltage supplied to the 1st-3 initialization voltage line VL13 may be different from each other.

The same elements may be arranged in each layer of the first circuit area PCA1, the second circuit area PCA2, and the third circuit area PCA3. Hereinafter, for convenience of illustration and description, reference numerals will be assigned to the elements of the pixel circuit PC arranged in the first circuit area PCA1, and the first circuit area PCA1 will be mainly described, which may be equally applied to the same elements of the second circuit area PCA2 and the third circuit area PCA3. Hereinafter, descriptions will be given with reference to FIGS. 7 to 18 together. Hereinafter, a connection electrode may be an electrode for transmitting a signal by electrically connecting conductive lines and electrodes (conductive patterns) arranged in different layers.

A first conductive layer may be disposed over the substrate 100. As illustrated in FIG. 7, the first conductive layer may include a conductive line 200, a first electrode 210, a lower first gate line GWLb, a reference voltage line VRL, a 1st-2 initialization voltage line VL12, a 1st-3 initialization voltage line VL13, and a repair line RL. In an embodiment, a barrier layer may be further arranged between the substrate 100 and the first conductive layer.

The first electrode 210 may be of an island type and may be arranged in each of the first circuit area PCA1, the second circuit area PCA2, and the third circuit area PCA3. The first electrode 210 may include a second gate electrode G12 of the first transistor T1, a lower second electrode C12b (see FIG. 18) of the first capacitor C1, and a lower first electrode C21b (see FIG. 18) of the second capacitor C2.

The conductive line 200 may extend in the x direction and may be arranged across the first circuit area PCA1, the second circuit area PCA2, and the third circuit area PCA3. The conductive line 200 may be a driving voltage line PL to which a first driving voltage ELVDD is applied. Hereinafter, the conductive line 200 and the driving voltage line PL may be interchangeably used. The conductive line 200 may include a main line 200m extending in the x direction in each circuit area and a protrusion portion 200p protruding from the main line 200m in the +y direction.

The lower first gate line GWLb, the reference voltage line VRL, the 1st-2 initialization voltage line VL12, and the 1st-3 initialization voltage line VL13 may extend in the x direction and may be arranged across the first circuit area PCA1, the second circuit area PCA2, and the third circuit area PCA3.

The repair line RL may extend in the x direction and may be arranged across the first circuit area PCA1, the second circuit area PCA2, and the third circuit area PCA3.

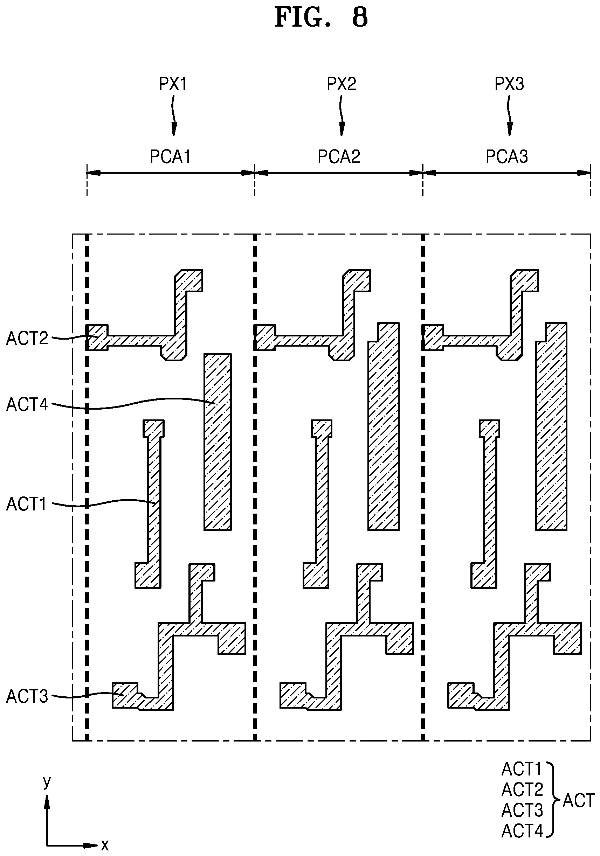

A first insulating layer 101 may be disposed over the substrate 100 to cover the first conductive layer, and as illustrated in FIG. 8, a semiconductor layer ACT including an oxide semiconductor may be arranged over the first insulating layer 101. The semiconductor layer ACT may include a first semiconductor layer ACT1, a second semiconductor layer ACT2, a third semiconductor layer ACT3, and a fourth semiconductor layer ACT4. The semiconductor layer ACT may include a source area, a drain area, and a channel area between the source area and the drain area in each of the first to sixth transistors T1 to T6. The source area or the drain area may be interpreted as a source electrode or a drain electrode of a transistor in some cases.

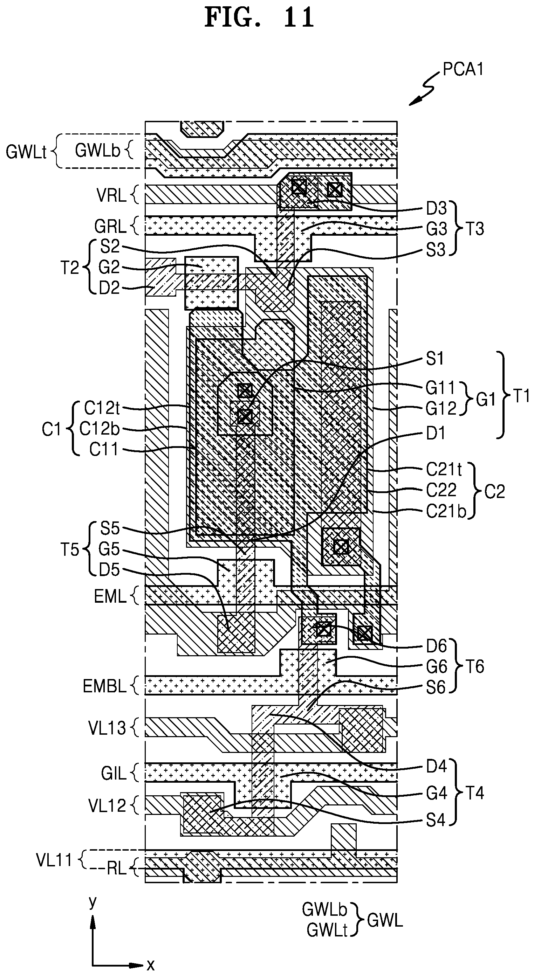

FIG. 11 is a diagram illustrating the transistors and capacitors of the first circuit area PCA1. Referring to FIG. 11, the first semiconductor layer ACT1 may include a source area S1 and a drain area D1 of the first transistor T1 and a source area S5 and a drain area D5 of the fifth transistor T5. The second semiconductor layer ACT2 may include a source area S2 and a drain area D2 of the second transistor T2 and a source area S3 and a drain area D3 of the third transistor T3. The third semiconductor layer ACT3 may include a source area S4 and a drain area D4 of the fourth transistor T4 and a source area S6 and a drain area D6 of the sixth transistor T6. The fourth semiconductor layer ACT4 may include a second electrode C22 (see FIG. 18) of the second capacitor C2.

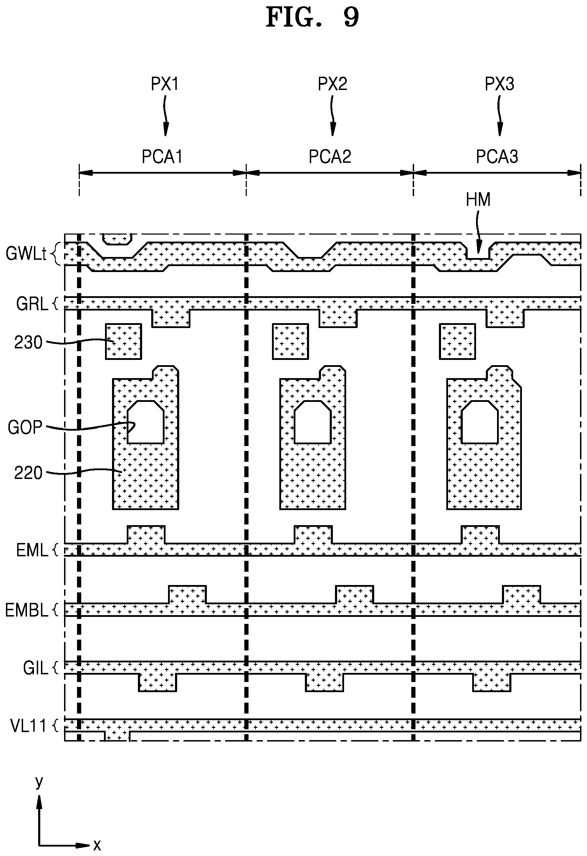

A second insulating layer 102 may be disposed over the first insulating layer 101 to cover the semiconductor layer ACT, and a second conductive layer may be disposed over the second insulating layer 102. As illustrated in FIG. 9, the second conductive layer may include a second electrode 220, a third electrode 230, an upper first gate line GWLt, a second gate line GIL, a third gate line GRL, a fourth gate line EML, a fifth gate line EMBL, and a 1st-1 initialization voltage line VL11.

The second electrode 220 and the third electrode 230 may be provided as an island type. The second electrode 220 and the third electrode 230 may be arranged in each of the first circuit area PCA1, the second circuit area PCA2, and the third circuit area PCA3. An opening GOP overlapping the first electrode 210 in a plan view may be defined in the second electrode 220.

The upper first gate line GWLt, the second gate line GIL, the third gate line GRL, the fourth gate line EML, the fifth gate line EMBL, and the 1st-1 initialization voltage line VL11 may extend in the x direction and may be arranged across the first circuit area PCA1, the second circuit area PCA2, and the third circuit area PCA3.

The upper first gate line GWLt may substantially overlap the lower first gate line GWLtb in a plan view and may include a groove HM corresponding to a portion of the lower first gate line GWLb. In an embodiment, a portion of the upper first gate line GWLt passing through the third circuit area PCA3 may include a groove HM corresponding to a portion of the lower first gate line GWLb.

As illustrated in FIG. 11, the second conductive layer may include gate electrodes G1 to G6 of the first to sixth transistors T1 to T6. The gate electrodes G1 to G6 may overlap the channel areas of the semiconductor layer ACT in a plan view.

Referring to FIG. 11, the second electrode 220 may include a first gate electrode G11 of the first transistor T1 and a first electrode C11 (see FIG. 18) of the first capacitor C1. The first gate electrode G11 may overlap the first semiconductor layer ACT1 in a plan view. The third electrode 230 may include a gate electrode G2 of the second transistor T2. The gate electrode G2 of the second transistor T2 may overlap the second semiconductor layer ACT2 in a plan view. A gate electrode G3 of the third transistor T3 may be a portion of the third gate line GRL overlapping the second semiconductor layer ACT2 in a plan view. A gate electrode G4 of the fourth transistor T4 may be a portion of the second gate line GIL overlapping the third semiconductor layer ACT3 in a plan view. A gate electrode G5 of the fifth transistor T5 may be a portion of the fourth gate line EML overlapping the first semiconductor layer ACT1 in a plan view. A gate electrode G6 of the sixth transistor T6 may be a portion of the fifth gate line EMBL overlapping the third semiconductor layer ACT3 in a plan view.

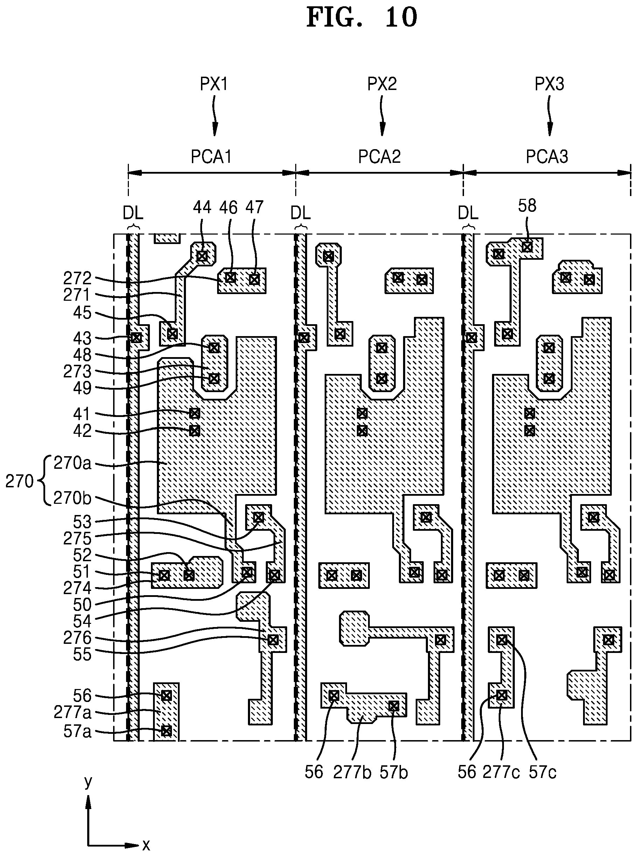

A third insulating layer 103 may be disposed over the second insulating layer 102 to cover the second conductive layer, and a third conductive layer may be disposed over the third insulating layer 103. As illustrated in FIG. 10, the third conductive layer may include a data line DL and connection electrodes 270, 271, 272, 273, 274, 275, 276, 277a, 277b, and 277c.

The data line DL may be arranged in each circuit area to extend in the y direction. The data line DL may be connected to the drain area D2 of the second transistor T2 through a contact hole 43 passing through the second insulating layer 102 and the third insulating layer 103. The data line DL may overlap the conductive line 200 in a plan view.

The connection electrode 270 may include a first area 270a overlapping the first electrode 210 and the second electrode 220 in a plan view and a second area 270b protruding from the first area 270a in the -y direction. The connection electrode 270 may connect the source area S1 of the first transistor T1 to the second gate electrode G12 of the first transistor T1 and the drain area D6 of the sixth transistor T6.

The first area 270a of the connection electrode 270 may be connected to the source area S1 of the first transistor T1 through a contact hole 42 passing through the second insulating layer 102 and the third insulating layer 103. The connection electrode 270 may include a source electrode connected to the source area S1 of the first transistor T1, an upper second electrode C12t (see FIG. 18) of the first capacitor C1, and an upper first electrode C21t (see FIG. 18) of the second capacitor C2. The first area 270a of the connection electrode 270 may be connected to the first electrode 210 through a contact hole 41 passing through the first insulating layer 101, the second insulating layer 102, and the third insulating layer 103. The first electrode 210 may be the second gate electrode G12 of the first transistor T1. As the connection electrode 270 is connected to the first electrode 210, the second gate electrode G12 of the first transistor T1 may be connected to the source area S1 of the first transistor T1.

The second area 270b of the connection electrode 270 may be connected to the drain area D6 of the sixth transistor T6 through a contact hole 50 passing through the second insulating layer 102 and the third insulating layer 103.

The connection electrode 271 may be connected to the gate electrode G2 of the second transistor T2 through a contact hole 45 passing through the third insulating layer 103. The connection electrode 271 may be connected to the upper first gate line GWLt through a contact hole 44 passing through the third insulating layer 103. The connection electrode 272 arranged in at least one of the first circuit area PCA1, the second circuit area PCA2, and the third circuit area PCA3 may be connected to the lower first gate line GWLb through a contact hole 58 passing through the first insulating layer 101, the second insulating layer 102, and the third insulating layer 103. The contact hole 58 may be located corresponding to a groove of the upper first gate line GWLt.

The connection electrode 272 may be connected to the drain area D3 of the third transistor T3 through a contact hole 46 passing through the second insulating layer 102 and the third insulating layer 103 and may be connected to the reference voltage line VRL through a contact hole 47 passing through the first insulating layer 101, the second insulating layer 102, and the third insulating layer 103.

The connection electrode 273 may be connected to the source area S2 of the second transistor T2 and the source area S3 of the third transistor T3 through a contact hole 48 passing through the second insulating layer 102 and the third insulating layer 103. The connection electrode 273 may be connected to the second electrode 220 through a contact hole 49 passing through the third insulating layer 103, to be connected to the first gate electrode G11 of the first transistor T1. The connection electrode 273 may be a node electrode corresponding to the first node N1 of FIG. 3. The connection electrode 273 may be a bridge electrode connecting at least two transistors. For example, the connection electrode 273 may be a bridge electrode connecting the first gate electrode G11 of the first transistor T1, the source area S2 of the second transistor T2, and the source area S3 of the third transistor T3.

The connection electrode 274 may be connected to the conductive line 200 through a contact hole 51 passing through the first insulating layer 101, the second insulating layer 102, and the third insulating layer 103. The connection electrode 274 may be connected to the drain area D5 of the fifth transistor T5 through a contact hole 52 passing through the second insulating layer 102 and the third insulating layer 103. Accordingly, the drain area D5 of the fifth transistor T5 may be connected to the conductive line 200.

The connection electrode 275 may be connected to the fourth semiconductor layer ACT4 through a contact hole 53 passing through the second insulating layer 102 and the third insulating layer 103. The connection electrode 275 may be connected to the conductive line 200 through a contact hole 54 passing through the first insulating layer 101, the second insulating layer 102, and the third insulating layer 103. Accordingly, the first driving voltage ELVDD may be supplied to the fourth semiconductor layer ACT4 including the second electrode C22 of the second capacitor C2.

The connection electrode 276 may be connected to the source area S6 of the sixth transistor T6 and the drain area D4 of the fourth transistor T4 through a contact hole 55 passing through the second insulating layer 102 and the third insulating layer 103. The connection electrode 276 may overlap a portion of the repair line RL in a plan view. The connection electrode 276 may be insulated from the repair line RL and may be connected to the repair line RL when a defect occurs later in the pixel circuit arranged in the circuit area.

In the first circuit area PCA1, the connection electrode 277a may be connected to the source area S4 of the fourth transistor T4 through a contact hole 56 passing through the second insulating layer 102 and the third insulating layer 103. The connection electrode 277a may be connected to the 1st-1 initialization voltage line VL11 through a contact hole 57a passing through the third insulating layer 103.

In the second circuit area PCA2, the connection electrode 277b may be connected to the source area S4 of the fourth transistor T4 through a contact hole 56 passing through the second insulating layer 102 and the third insulating layer 103. The connection electrode 277b may be connected to the 1st-2 initialization voltage line VL12 through a contact hole 57b passing through the first insulating layer 101, the second insulating layer 102, and the third insulating layer 103.

In the third circuit area PCA3, the connection electrode 277c may be connected to the source area S4 of the fourth transistor T4 through a contact hole 56 passing through the second insulating layer 102 and the third insulating layer 103. The connection electrode 277c may be connected to the 1st-3 initialization voltage line VL13 through a contact hole 57c passing through the first insulating layer 101, the second insulating layer 102, and the third insulating layer 103.

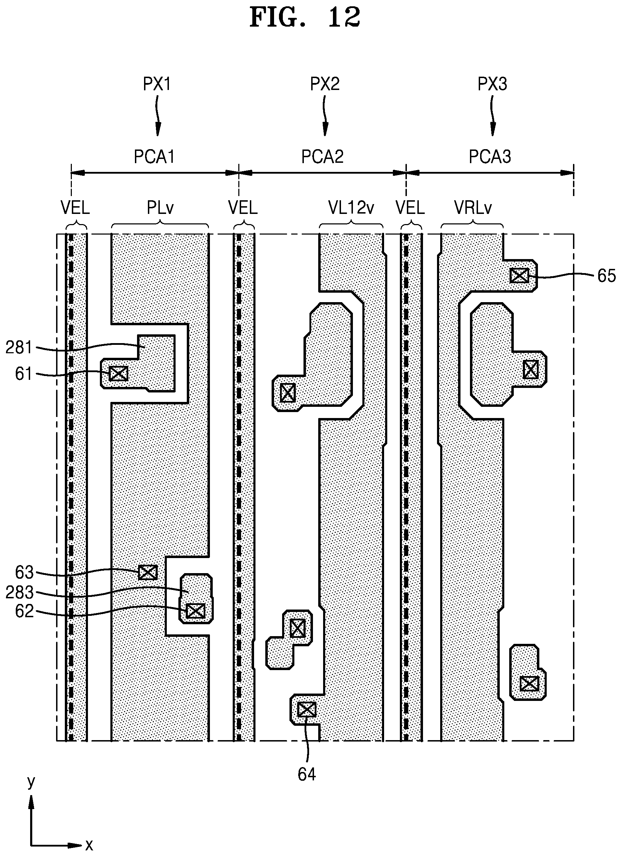

A fourth insulating layer 104 may be disposed over the third insulating layer 103 to cover the third conductive layer, and a fourth conductive layer may be disposed over the fourth insulating layer 104. As illustrated in FIGS. 12 to 15, the fourth conductive layer may include a plurality of vertical conductive lines VVL and connection electrodes 281 and 283.

The connection electrode 281 may be connected to the connection electrode 270 through a contact hole 61 passing through the fourth insulating layer 104. The connection electrode 281 may be arranged to cover and overlap the connection electrode 273 that is a node electrode in a plan view. The first electrode 210 may be disposed under the connection electrode 273, and the connection electrode 281 may be disposed over the connection electrode 273. The connection electrode 281 may substantially entirely cover the connection electrode 273, and the first electrode 210 may substantially entirely cover the connection electrode 273. The connection electrode 281 may function as an upper shielding layer of the connection electrode 273, and the first electrode 210 may function as a lower shielding layer of the connection electrode 273.

The connection electrode 283 may be connected to the connection electrode 276 through a contact hole 62 passing through the fourth insulating layer 104, to be connected to the source area S6 of the sixth transistor T6.

Referring to FIG. 13, the vertical conductive lines VVL may include a shielding line VEL, a first vertical conductive line VVL1 arranged in the first circuit area PCA1, a second vertical conductive line VVL2 arranged in the second circuit area PCA2, and a third vertical conductive line VVL3 arranged in the third circuit area PCA3.

The shielding line VEL may overlap the data line DL in a plan view in each of the first circuit area PCA1, the second circuit area PCA2, and the third circuit area PCA3. The shielding line VEL may correspond to the shielding line VEL illustrated in FIG. 4A. The shielding line VEL may not be connected to the pixels PX in each of the first circuit area PCA1, the second circuit area PCA2, and the third circuit area PCA3. As illustrated in FIGS. 5A to 5D, the shielding line VEL may be connected to a shielding voltage supply line PVEL arranged in the peripheral area PA, to receive a shielding voltage VES, which is a constant voltage, from the shielding voltage supply line PVEL.

In an embodiment, the shielding line VEL may receive, from the shielding voltage supply line PVEL, a separate constant voltage different from a plurality of voltages (e.g., the first driving voltage ELVDD, the reference voltage Vref, and the initialization voltage Vint) supplied to the pixel PX. In an embodiment, the shielding line VEL may receive, from the shielding voltage supply line PVEL, one of a plurality of voltages (e.g., the first driving voltage ELVDD, the reference voltage Vref, and the initialization voltage Vint) supplied to the pixel PX. In an embodiment, the shielding line VEL may receive, from the shielding voltage supply line PVEL, one of constant voltages (e.g., a high voltage VGH, a low voltage VGL, and a ground voltage) supplied to a gate driving circuit supplying electrical signals to the pixel PX.

The first vertical conductive line VVL1, the second vertical conductive line VVL2, and the third vertical conductive line VVL3 may be one of a vertical driving voltage line PLv, a first vertical initialization voltage line VL11v, a second vertical initialization voltage line VL12v, a third vertical initialization voltage line VL13v, a vertical reference voltage line VRLv, and a vertical common voltage line EOL. Two of the first vertical conductive line VVL1, the second vertical conductive line VVL2, and the third vertical conductive line VVL3 may be the same vertical conductive lines VVL. The vertical driving voltage line PLv, the first vertical initialization voltage line VL11v, the second vertical initialization voltage line VL12v, the third vertical initialization voltage line VL13v, the vertical reference voltage line VRLv, and the vertical common voltage line EOL may be arranged alternately in the x direction according to a certain rule.

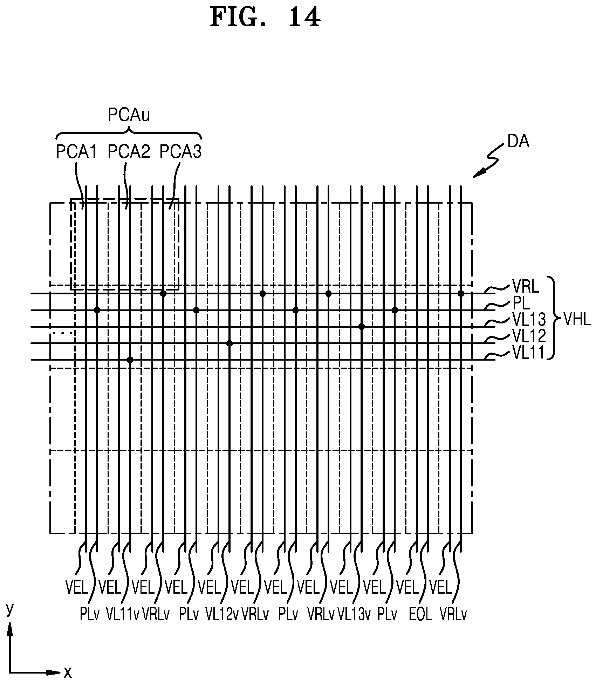

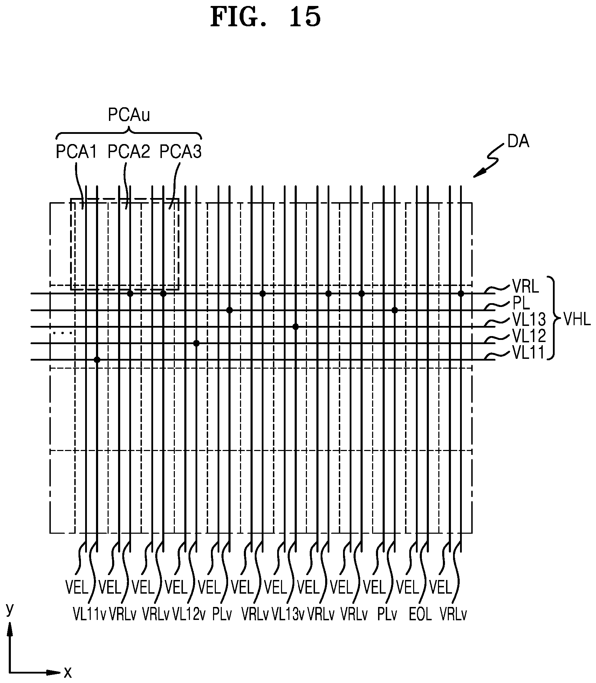

Referring to FIGS. 14 and 15, the vertical conductive lines VVL may be electrically connected to horizontal conductive lines VHL extending in the x direction. The horizontal conductive lines VHL may include a driving voltage line PL (the conductive line 200), a 1st-1 initialization voltage line VL11, a 1st-2 initialization voltage line VL12, a 1st-3 initialization voltage line VL13, and a reference voltage line VRL. The driving voltage line PL may be electrically connected to the vertical driving voltage line PLv to have a mesh structure in the display area DA. The 1st-1 initialization voltage line VL11 may be electrically connected to the first vertical initialization voltage line VL11v to have a mesh structure in the display area DA. The 1st-2 initialization voltage line VL12 may be electrically connected to the second vertical initialization voltage line VL12v to have a mesh structure in the display area DA. The 1st-3 initialization voltage line VL13 may be electrically connected to the third vertical initialization voltage line VL13v to have a mesh structure in the display area DA. The reference voltage line VRL may be electrically connected to the vertical reference voltage line VRLv to have a mesh structure in the display area DA. The shielding line VEL and the vertical common voltage line EOL may not have a mesh structure and may be a straight line having a stripe shape extending in the y direction.

In an embodiment, as illustrated in FIG. 14, in four unit circuit areas PCAu, the first vertical conductive line VVL1 may be the vertical driving voltage line PLv, and as the second vertical conductive line VVL2 and the third vertical conductive line VVL3, the first vertical initialization voltage line VL11v/the vertical reference voltage line VRLv, the second vertical initialization voltage line VL12v/the vertical reference voltage line VRLv, the vertical reference voltage line VRLv/ the third vertical initialization voltage line VL13v, and the vertical common voltage line EOL/the vertical reference voltage line VRLv may be alternately arranged.

In an embodiment, as illustrated in FIG. 15, in four unit circuit areas PCAu, as the first vertical conductive line VVL1, the second vertical conductive line VVL2, and the third vertical conductive line VVL3, the first vertical initialization voltage line VL11v/a pair of vertical reference voltage lines VRLv, the second vertical initialization voltage line VL12v/the vertical driving voltage line PLv/the vertical reference voltage line VRLv, third vertical initialization voltage line VL13v/a pair of vertical reference voltage lines VRLv, and the vertical driving voltage line PLv/the vertical common voltage line EOL/the vertical reference voltage line VRLv may be alternately arranged.

FIG. 12 illustrates an example in which the first vertical conductive line VVL1 is the vertical driving voltage line PLv, the second vertical conductive line VVL2 is the second vertical initialization voltage line VL12v, and the third vertical conductive line VVL3 is the vertical reference voltage line VRLv.

The vertical driving voltage line PLv may be connected to the connection electrode 274 arranged in the first circuit area PCA1, through a contact hole 63 passing through the fourth insulating layer 104. Because the connection electrode 274 is connected to the conductive line 200, the vertical driving voltage line PLv may be electrically connected to the driving voltage line PL.

The second vertical initialization voltage line VL12v may be connected to the connection electrode 277b arranged in the second circuit area PCA2, through a contact hole 64 passing through the fourth insulating layer 104. Because the connection electrode 277b is connected to the 1st-2 initialization voltage line VL12, the second vertical initialization voltage line VL12v may be electrically connected to the 1st-2 initialization voltage line VL12.

The vertical reference voltage line VRLv may be connected to the connection electrode 272 arranged in the third circuit area PCA3, through a contact hole 65 passing through the fourth insulating layer 104. Because the connection electrode 272 is connected to the reference voltage line VRL, the vertical reference voltage line VRLv may be electrically connected to the reference voltage line VRL.

Although not illustrated, voltage supply lines electrically connected to the horizontal conductive lines VHL and/or the vertical conductive lines VVL may be further arranged in the peripheral area PA. The voltage supply lines may be arranged on at least one of the upper side, the lower side, the left side, and the right side of the display area DA.

A fifth insulating layer 105 may be disposed over the fourth insulating layer 104 to cover the fourth conductive layer, and an organic light-emitting diode OLED may be disposed as a display element over the fifth insulating layer 105. The organic light-emitting diode OLED may include a pixel electrode 311, an opposite electrode 315, and an intermediate layer between the pixel electrode 311 and the opposite electrode 315.

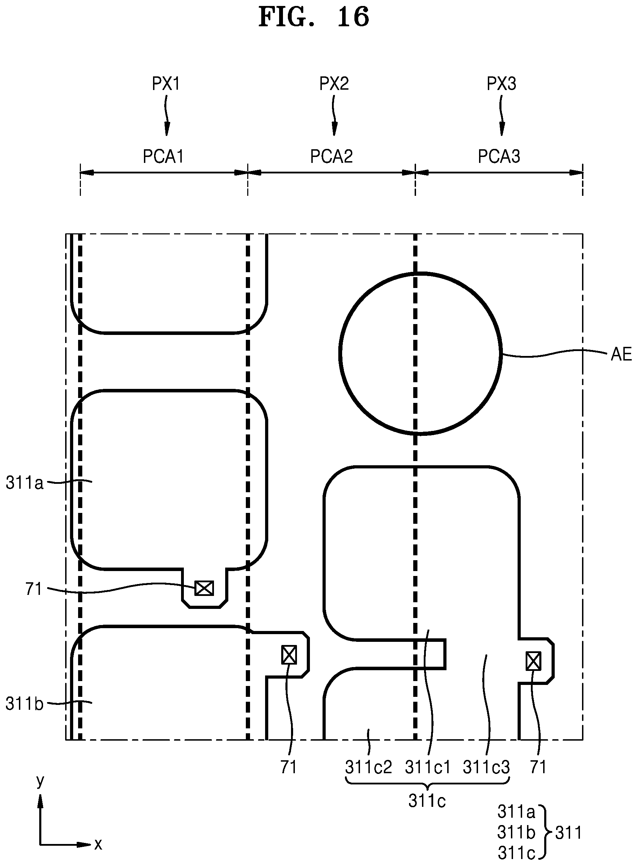

The pixel electrode 311 may be connected to the first transistor T1 by being connected to the connection electrode 283, which is a lower conductive pattern, through a contact hole 71 of the fifth insulating layer 105. As illustrated in FIG. 16, a pixel electrode 311a connected to the pixel circuit of the first pixel PX1 may be connected to the first transistor T1 by being connected to the connection electrode 283 arranged in the first circuit area PCA1. A pixel electrode 311b connected to the pixel circuit of the second pixel PX2 may be connected to the first transistor T1 by being connected to the connection electrode 283 arranged in the second circuit area PCA2. A pixel electrode 311c connected to the pixel circuit of the third pixel PX3 may be connected to the first transistor T1 by being connected to the connection electrode 283 arranged in the third circuit area PCA3. The pixel electrode 311c may have a '⊃' shape by including a first area 311c1 and a second area 311c2, which are square-shaped, and a third area 311c3 connecting the first area 311c1 with the second area 311c2. An auxiliary electrode AE may be further arranged in the same layer as the pixel electrodes 311. The auxiliary electrode AE may be arranged between the pixel electrodes 311c of the third pixel PX3. The auxiliary electrode AE may contact the opposing electrode 315 in the display area DA. In an embodiment, the auxiliary electrode AE may be electrically connected to the vertical common voltage line EOL in the display area DA.

As illustrated in FIGS. 17 and 18, a sixth insulating layer 106, which is a pixel definition layer, may be disposed over the pixel electrode 311 to cover an edge of the pixel electrode 311. An opening 106OP may be defined in the sixth insulating layer 106 to expose a portion of the pixel electrode 311 and define an emission area. The sixth insulating layer 106 may include a single layer or multiple layers including an organic insulating layer and/or an inorganic insulating layer.

The intermediate layer may include an emission layer 313, a first functional layer under the emission layer 313, and/or a second functional layer over the emission layer 313. The first functional layer may include a hole transport layer ("HTL"). Alternatively, the first functional layer may include a hole injection layer ("HIL") and an HTL. The second functional layer may include an electron transport layer ("ETL") and/or an electron injection layer ("EIL"). The first functional layer and the second functional layer may be integrally formed to correspond to a plurality of organic light-emitting diodes OLED included in the display area DA. The first functional layer or the second functional layer may be omitted. FIGS. 17 and 18 illustrate an organic light-emitting diode OLEDa electrically connected to the pixel circuit arranged in the first circuit area PCA1.

The opposite electrode 315 may be integrally formed to correspond to a plurality of organic light-emitting diodes OLED arranged in the display area DA.

FIG. 19 is a diagram illustrating the arrangement of a data line and a signal line according to a comparative example. In the comparative example, the conductive line 200, which is the driving voltage line PL, may be disposed under the data line DL to overlap the data line DL in a plan view, the vertical driving voltage line PLv may be disposed over the data line DL to overlap the data line DL in a plan view, and the vertical driving voltage line PLv may be disposed over the connection electrode 270 to overlap the connection electrode 270 in a plan view.

In the comparative example, a capacitor C' may be formed between the data line DL and the driving voltage line PL (the conductive line 200) to which the first driving voltage ELVDD is supplied and between the data line DL and the vertical driving voltage line PLv to which the first driving voltage ELVDD is supplied. When the data signal DATA changes, the first driving voltage ELVDD supplied to the driving voltage line PL may change (rise or fall) instantaneously due to the coupling of the capacitor C'. Due to a change in the first driving voltage ELVDD, the voltage of the second terminal of the first transistor T1, that is, the voltage of the second node N2, may change due to the coupling of the second capacitor C2 connected to the driving voltage line PL, which may change the gate-source voltage of the first transistor T1. Accordingly, the pixel PX may emit light with a brightness different from a given brightness, and a multi-line horizontal crosstalk causing spots in an image may occur.

On the other hand, in the embodiment illustrated in FIG. 18, the shielding line VEL may be disposed over the data line DL. Because the shielding line VEL is not electrically connected to the pixel PX, even when the data signal DATA changes, the voltage change of the shielding line VEL may not affect the voltage change of the second terminal of the first transistor T1 and therefore the gate-source voltage change of the first transistor T1 may be minimized.

In the pixel circuit in which the vertical driving voltage line PLv among the vertical conductive lines VVL overlaps the connection electrode 270 including the source area S1 of the first transistor T1 in a plan view, a capacitor may be formed due to the vertical driving voltage line PLv and the connection electrode 270 and thus the capacitance of the second capacitor C2 may increase. When the data signal DATA changes due to an increase in the capacitance of the second capacitor C2, a multi-line horizontal crosstalk due to the coupling of the second capacitor C2 may increase. In an embodiment, in the circuit area of at least one of the first pixel PX1, the second pixel PX2, and the third pixel PX3 constituting a unit pixel, the vertical driving voltage line PLv may not be disposed over the connection electrode 270. The vertical driving voltage line PLv may not be arranged in the second circuit area PCA2 in which a pixel with a great brightness contribution in the unit pixel, for example, the second pixel PX2 that is a green pixel, is arranged.

In an embodiment, the second vertical conductive line VVL2 arranged in the second circuit area PCA2 may be one of the first vertical initialization voltage line VL11v, the second vertical initialization voltage line VL12v, the third vertical initialization voltage line VL13v, the vertical reference voltage line VRLv, and the vertical common voltage line EOL, excluding the vertical driving voltage line PLv. For example, the vertical driving voltage line PLv and the vertical reference voltage line VRLv, which are the second vertical conductive line VVL2 and the third vertical conductive line VVL3 of the second unit circuit area PCAu, may be replaced by the vertical reference voltage line VRLv and the vertical driving voltage line PLv as illustrated in FIG. 20. FIG. 21 is a cross-sectional view of an example in which the vertical reference voltage line VRLv is arranged as the second vertical conductive line VVL2 in the second circuit area PCA2.

The pixel circuit of the pixel according to embodiments is not limited to the pixel circuit illustrated in FIG. 3. In other embodiments, the disclosure may be applied to various pixel circuits including a first capacitor C1 and a second capacitor C2 connected to the second terminal (source) of the first transistor T1.

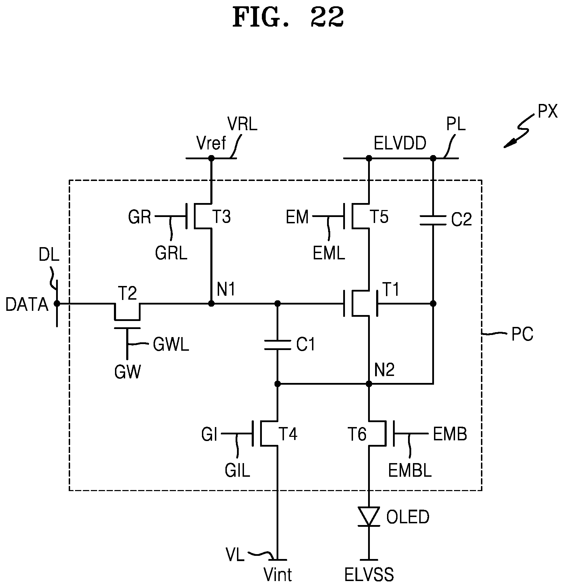

FIGS. 22 to 26 illustrate equivalent circuits of a pixel according to embodiments.

The pixel circuit PC of the pixel PX of FIG. 22 may be different from the pixel circuit PC of FIG. 3 in that the fourth transistor T4 is connected to the second node N2 and the initialization voltage line VL. The fourth transistor T4 may be turned on by the second gate signal GI received from the second gate line GIL, to transmit the initialization voltage Vint received from the initialization voltage line VL, to the second node N2.

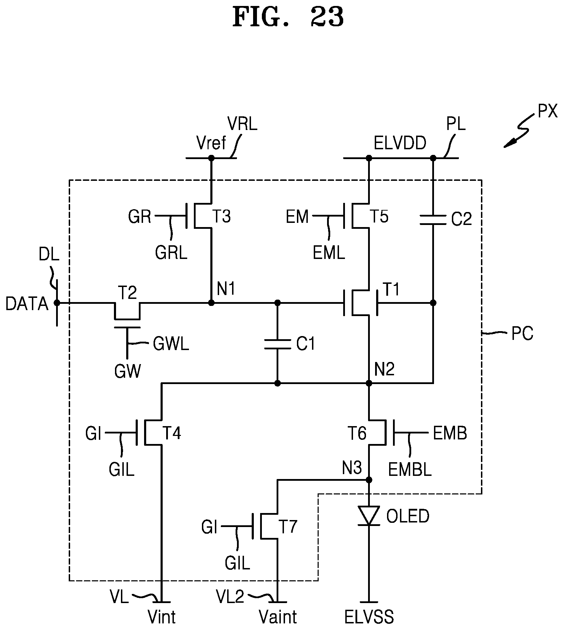

The pixel circuit PC of the pixel PX of FIG. 23 may be different from the pixel circuit PC of FIG. 22 in that a seventh transistor T7 is additionally connected to the third node N3 and a second initialization voltage line VL2. The second initialization voltage line VL2 may be provided separately from the initialization voltage line VL and may be configured to supply a second initialization voltage Vaint that is different from the initialization voltage Vint. In an embodiment, the second initialization voltage Vaint may have a higher voltage level than the initialization voltage Vint.

The seventh transistor T7 may be turned on by the second gate signal GI received through the second gate line GIL, to transmit the second initialization voltage Vaint received through the second initialization voltage line VL2, to the third node N3. The second node N2 and the third node N3 may be initialized to different voltages by the fourth transistor T4 and the seventh transistor T7, respectively.

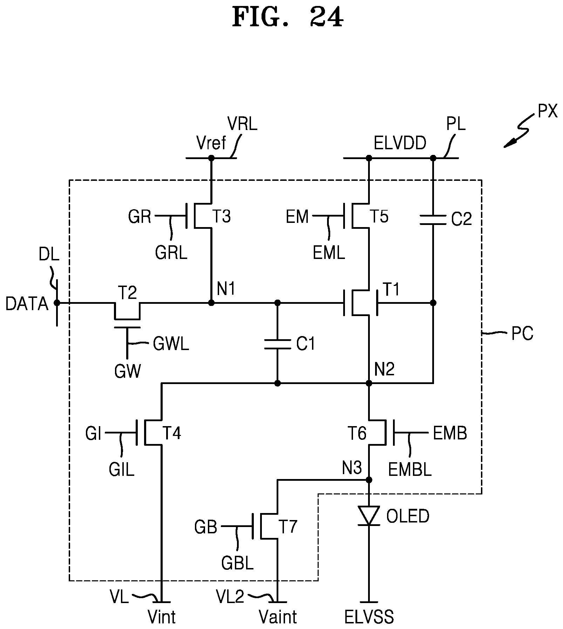

The pixel circuit PC of the pixel PX of FIG. 24 may be different from the pixel circuit PC of FIG. 23 in that the gate of the seventh transistor T7 is connected to a sixth gate line GBL to receive a sixth gate signal GB. The fourth transistor T4 and the seventh transistor T7 may be connected to different gate lines and controlled by different gate signals to independently control the initialization timing of the second node N2 and the third node N3.

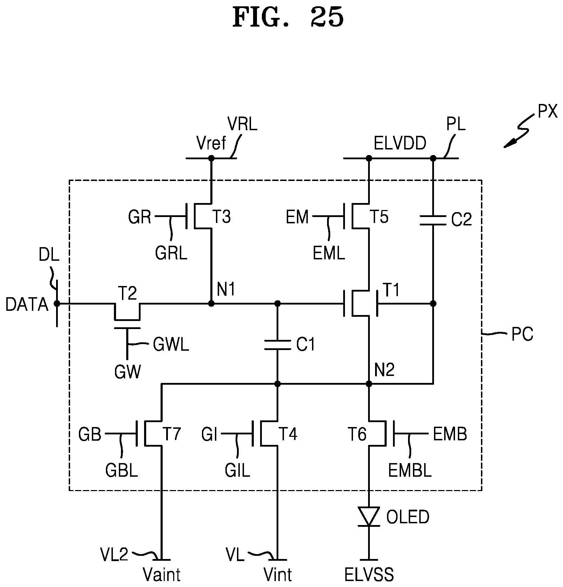

The pixel circuit PC of the pixel PX of FIG. 25 may be different from the pixel circuit PC of FIG. 24 in that the seventh transistor T7 is connected to the second node N2 and the second initialization voltage line VL2. The fourth transistor T4 and the seventh transistor T7 may be connected to different gate lines and controlled by different gate signals to precisely control the initialization of the second node N2.

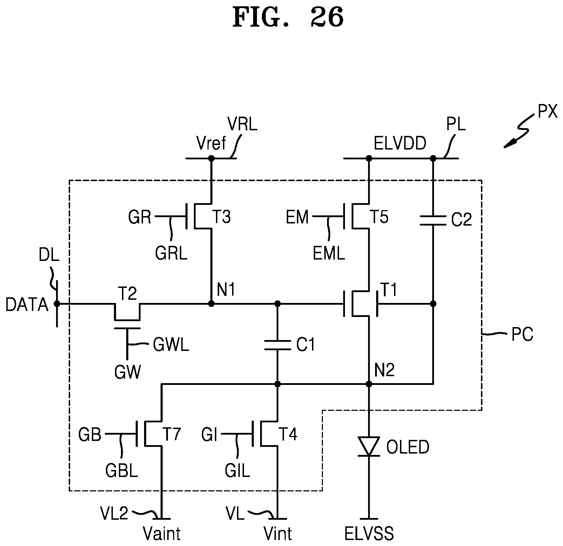

The pixel circuit PC of the pixel PX of FIG. 26 may be different from the pixel circuit PC of the pixel PX of FIG. 25 in that the sixth transistor T6 is omitted.

Like in the pixel PX illustrated in FIG. 3, in the pixel PX illustrated in FIGS. 22 to 26, a shielding line may be disposed over the data line DL to overlap the data line DL in a plan view and may not be connected to the pixel PX. A shielding voltage supplied to the shielding line may be a separate voltage different from the first driving voltage ELVDD, the reference voltage Vref, the initialization voltage Vint, and the second initialization voltage Vaint or may be one of the first driving voltage ELVDD, the reference voltage Vref, the initialization voltage Vint, the second initialization voltage Vaint, the high voltage VGH, the low voltage VGL, and the ground voltage. Also, the second vertical conductive line VVL2 arranged in the second circuit area PCA2 in which the pixel circuit of the second pixel PX2 is arranged may be one of the vertical conductive lines other than the vertical driving voltage line PLv.

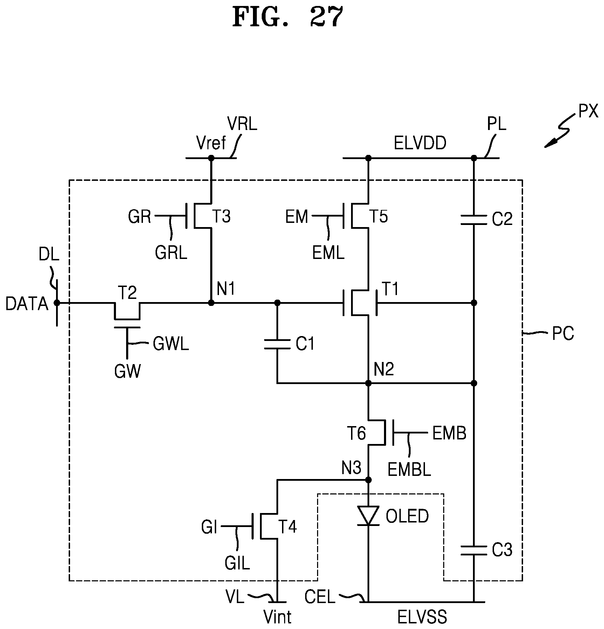

FIGS. 27 to 32 are equivalent circuit diagrams of a pixel according to embodiments.

The pixel circuit PC of the pixel PX of FIG. 27 may be different from the pixel circuit PC of FIG. 3 in that a third capacitor C3 is added. The third capacitor C3 may be connected between the second node N2 and a common voltage line CEL.

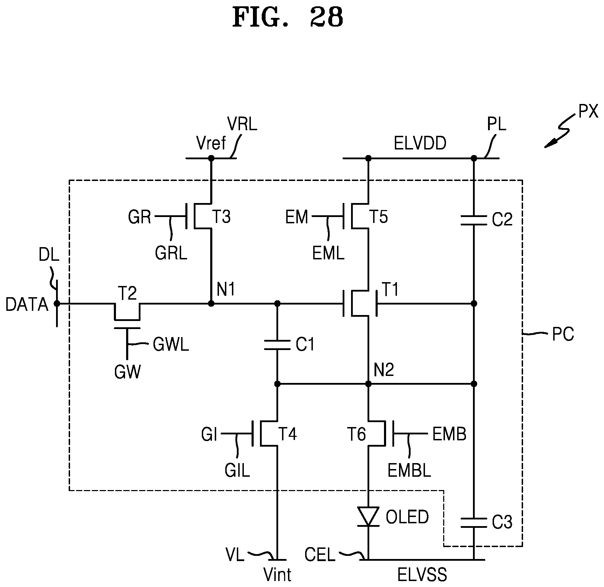

The pixel circuit PC of the pixel PX of FIG. 28 may be different from the pixel circuit PC of FIG. 20 in that a third capacitor C3 is added. The third capacitor C3 may be connected between the second node N2 and a common voltage line CEL.

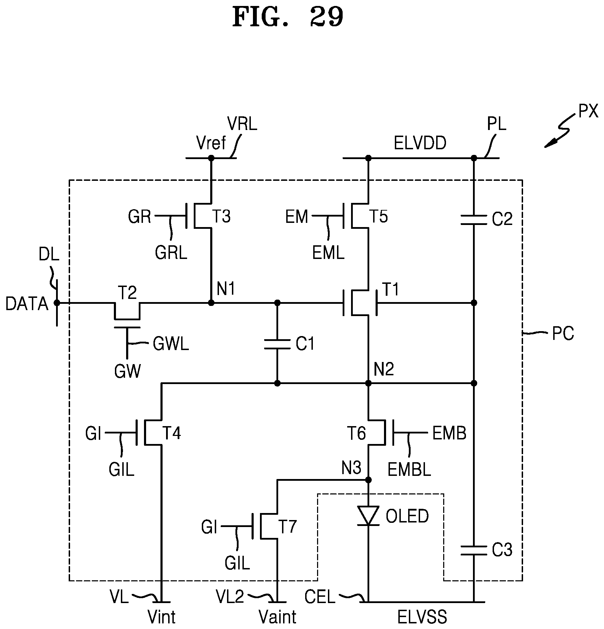

The pixel circuit PC of the pixel PX of FIG. 29 may be different from the pixel circuit PC of FIG. 21 in that a third capacitor C3 is added. The third capacitor C3 may be connected between the second node N2 and a common voltage line CEL.

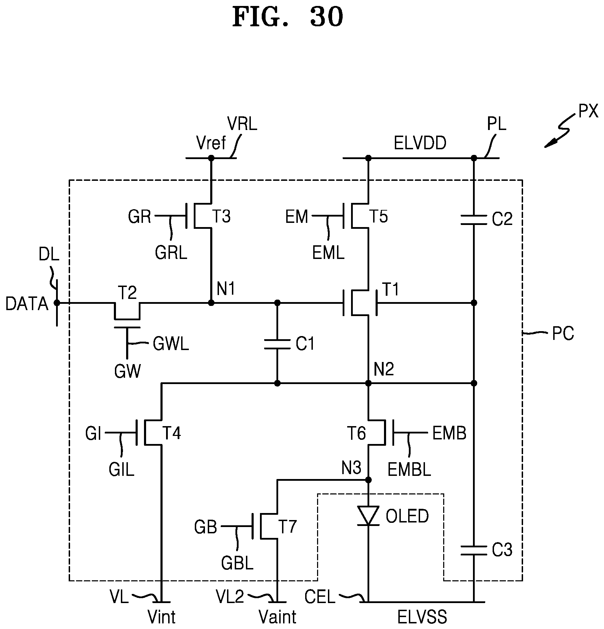

The pixel circuit PC of the pixel PX of FIG. 30 may be different from the pixel circuit PC of FIG. 22 in that a third capacitor C3 is added. The third capacitor C3 may be connected between the second node N2 and a common voltage line CEL.

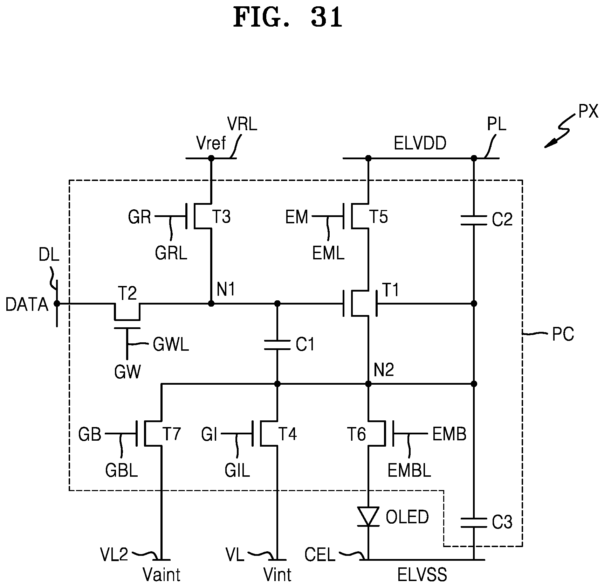

The pixel circuit PC of the pixel PX of FIG. 31 may be different from the pixel circuit PC of FIG. 23 in that a third capacitor C3 is added. The third capacitor C3 may be connected between the second node N2 and a common voltage line CEL.

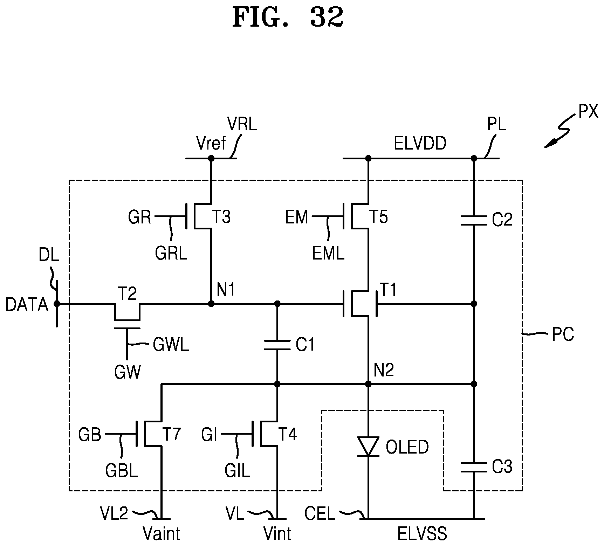

The pixel circuit PC of the pixel PX of FIG. 32 may be different from the pixel circuit PC of FIG. 24 in that a third capacitor C3 is added. The third capacitor C3 may be connected between the second node N2 and a common voltage line CEL.

In the embodiments illustrated in FIGS. 27 to 32, the common voltage line CEL may extend in the x direction and may be arranged to across the first circuit area PCA1, the second circuit area PCA2, and the third circuit area PCA3. The common voltage line CEL may be electrically connected to the vertical common voltage line EOL. In an embodiment, the common voltage line CEL may be arranged in the same layer as the first conductive layer.

Like in FIG. 11 in which the embodiment of FIG. 3 is implemented, also in the pixels PX illustrated in FIGS. 27 to 32, the shielding line may overlap the data line DL in a plan view and the shielding line may overlap the conductive line 200 in a plan view. The pixels PX illustrated in FIGS. 27 to 32 may further include the third capacitor C3, thereby further minimizing a voltage change in the driving voltage line PL due to a change in the data signal DATA. Also, the second vertical conductive line VVL2 arranged in the second circuit area PCA2 in which the pixel circuit of the second pixel PX2 is arranged may be one of the vertical conductive lines other than the vertical driving voltage line PLv.

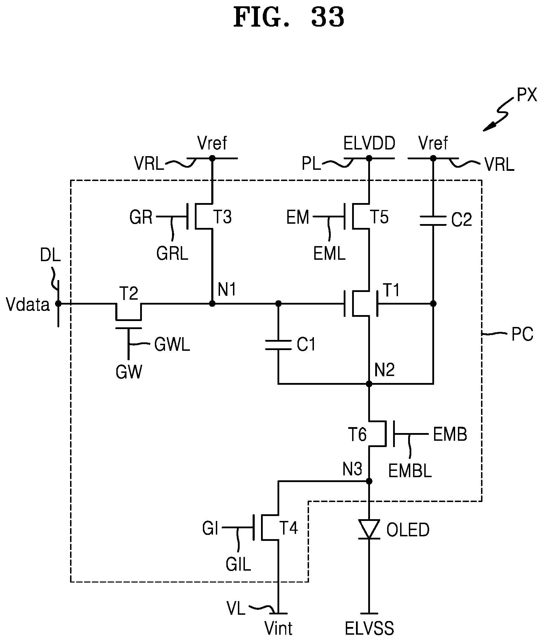

FIG. 33 is an equivalent circuit diagram of a pixel according to an embodiment.

The pixel circuit PC of the pixel PX of FIG. 33 may be different from the pixel circuit PC of FIG. 3 in that the second capacitor C2 is connected between the reference voltage line VRL and the second node N2. Other configurations thereof may be the same as those of the pixel circuit PC illustrated in FIG. 3, and thus, redundant descriptions thereof will be omitted for conciseness.

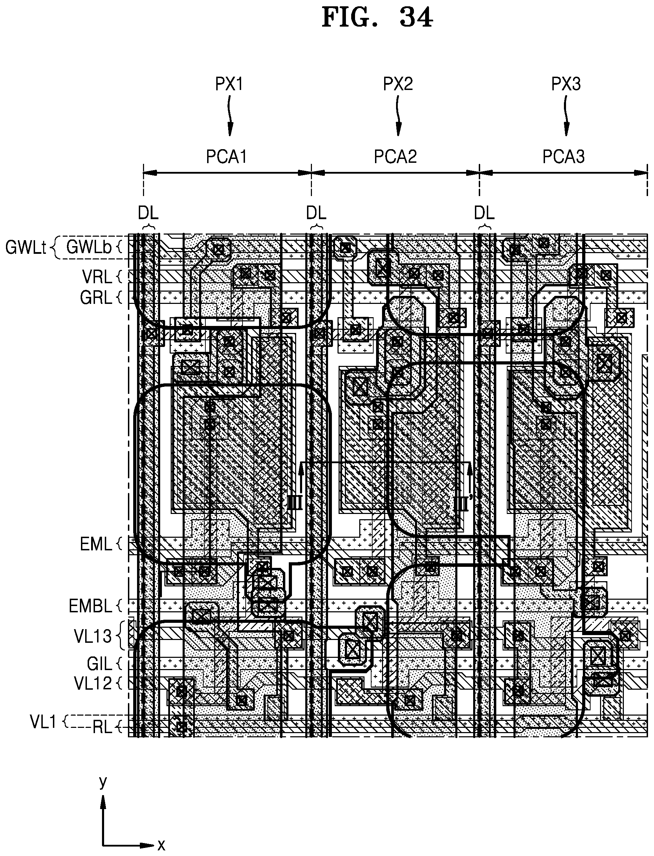

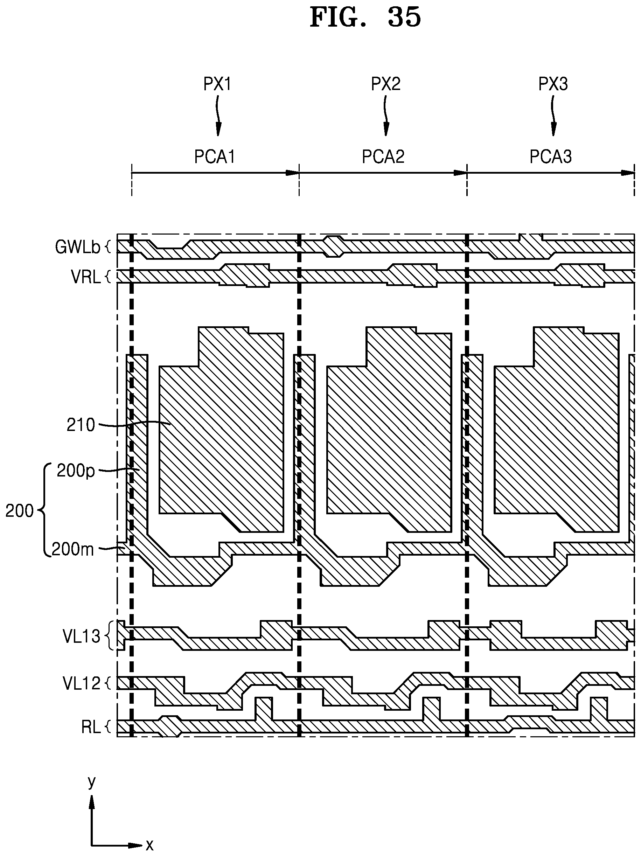

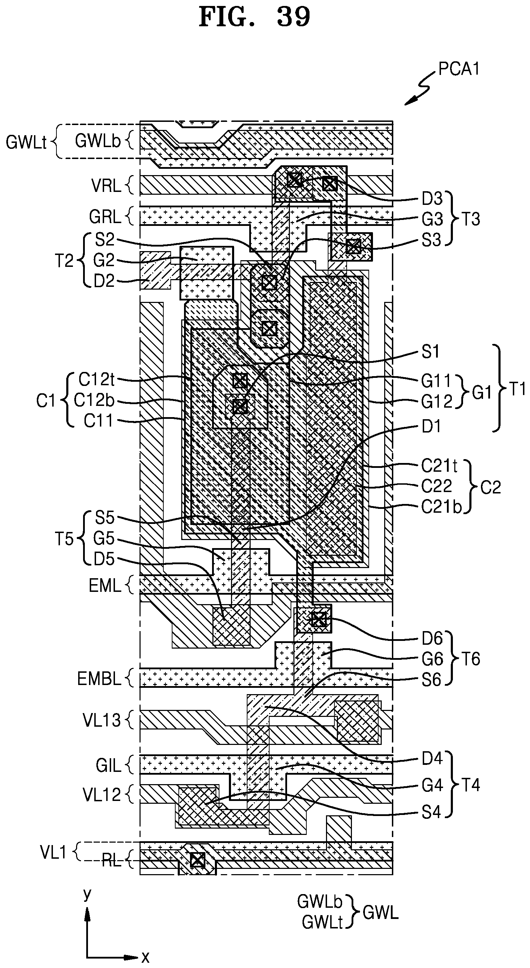

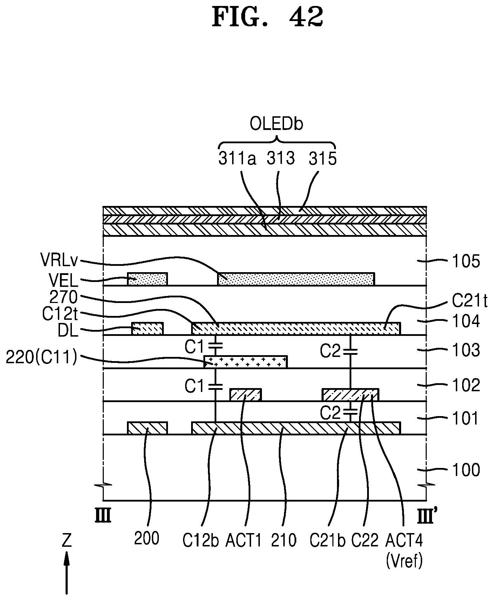

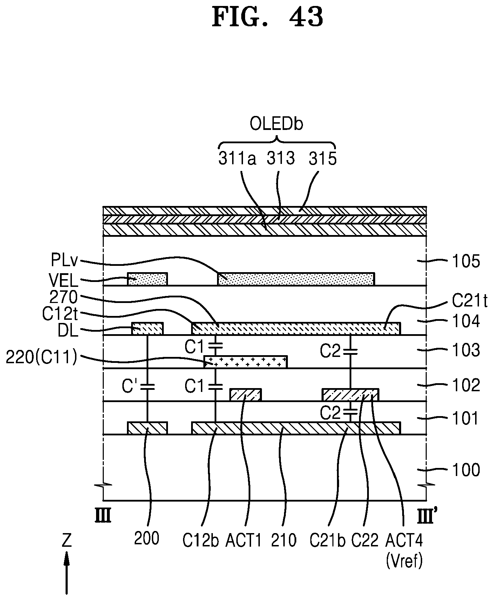

FIG. 34 is a layout diagram schematically illustrating the position of transistors and capacitors of the pixel illustrated in FIG. 33. FIGS. 35 to 41 are layout diagrams schematically illustrating the components of the pixel of FIG. 33 on a layer-by-layer basis. FIG. 39 is a diagram illustrating the transistors and capacitors of the first circuit area PCA1. FIG. 42 is a cross-sectional view of the pixel taken along line III-III' of FIG. 34. FIG. 43 is a diagram illustrating the arrangement of a data line and a signal line according to a comparative example. Hereinafter, like reference numerals will be assigned to like components as those described in FIGS. 6 to 18, redundant descriptions thereof will be omitted, and differences therebetween will be mainly described.

Referring to FIG. 35, a first conductive layer may be disposed over the substrate 100. The first conductive layer may include a conductive line 200 as a driving voltage line PL, a first electrode 210, a lower first gate line GWLb, a reference voltage line VRL, a 1st-2 initialization voltage line VL12, a 1st-3 initialization voltage line VL13, and a repair line RL.

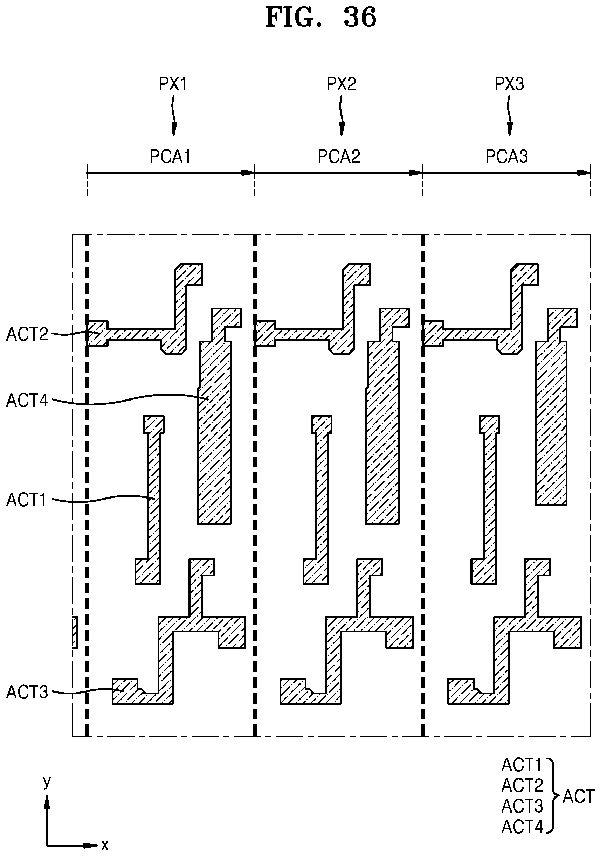

Referring to FIG. 36, a first insulating layer 101 may be disposed over the substrate 100 to cover the first conductive layer, and a semiconductor layer ACT including an oxide semiconductor may be arranged over the first insulating layer 101.

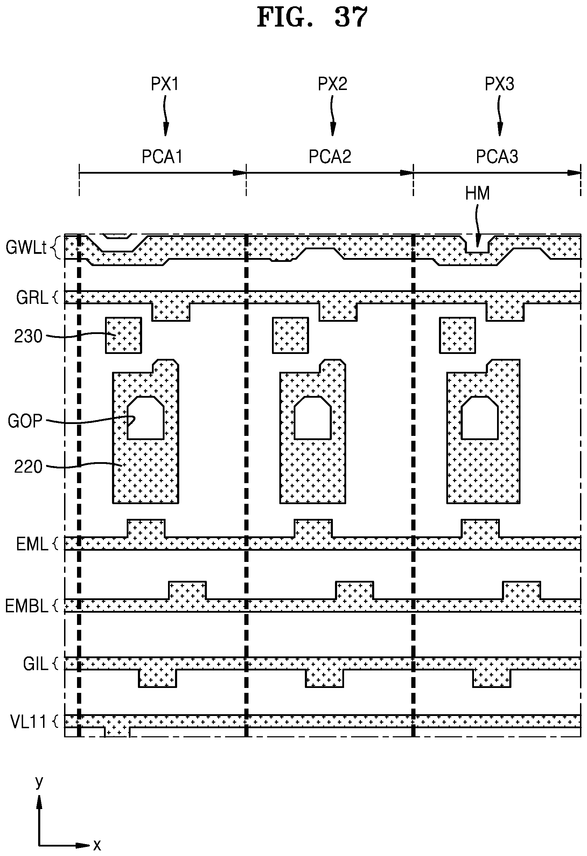

Referring to FIG. 37, a second insulating layer 102 may be disposed over the first insulating layer 101 to cover the semiconductor layer ACT, and a second conductive layer may be disposed over the second insulating layer 102. The second conductive layer may include a second electrode 220, a third electrode 230, an upper first gate line GWLt, a second gate line GIL, a third gate line GRL, a fourth gate line EML, a fifth gate line EMBL, and a 1st-1 initialization voltage line VL11.

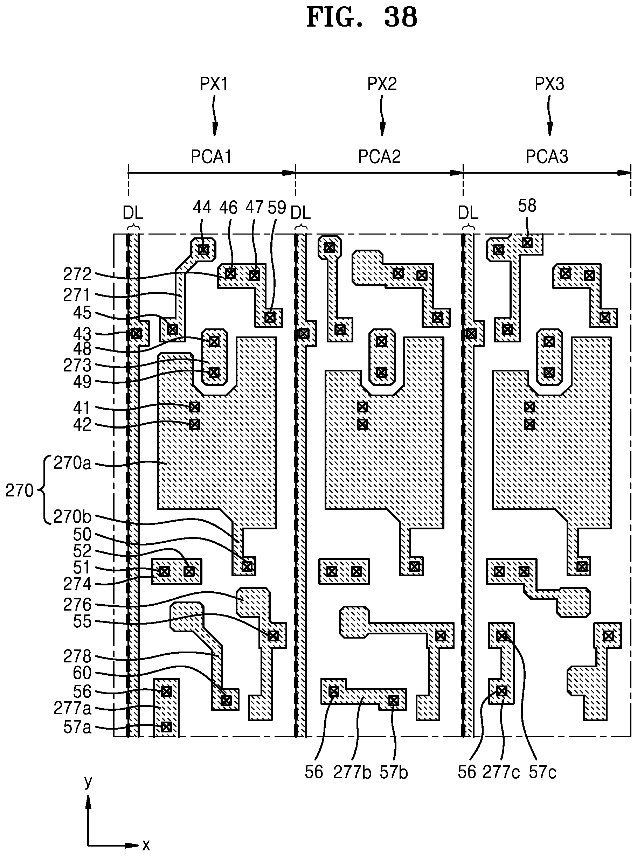

Referring to FIG. 38, a third insulating layer 103 may be disposed over the second insulating layer 102 to cover the second conductive layer, and a third conductive layer may be disposed over the third insulating layer 103. The third conductive layer may include a data line DL and connection electrodes 270, 271, 272, 273, 274, 275, 276, 277a, 277b, 277c, and 278.

The connection electrode 272 may be connected to the drain area D3 of the third transistor T3 through a contact hole 46 passing through the second insulating layer 102 and the third insulating layer 103 and may be connected to the reference voltage line VRL through a contact hole 47 passing through the first insulating layer 101, the second insulating layer 102, and the third insulating layer 103. The connection electrode 272 may be connected to the fourth semiconductor layer ACT4 through a contact hole 59 passing through the second insulating layer 102 and the third insulating layer 103. Accordingly, the reference voltage Vref may be supplied to the fourth semiconductor layer ACT4.

The connection electrode 278 may be connected to the source area S4 of the fourth transistor T4 through a contact hole 60 passing through the second insulating layer 102 and the third insulating layer 103.

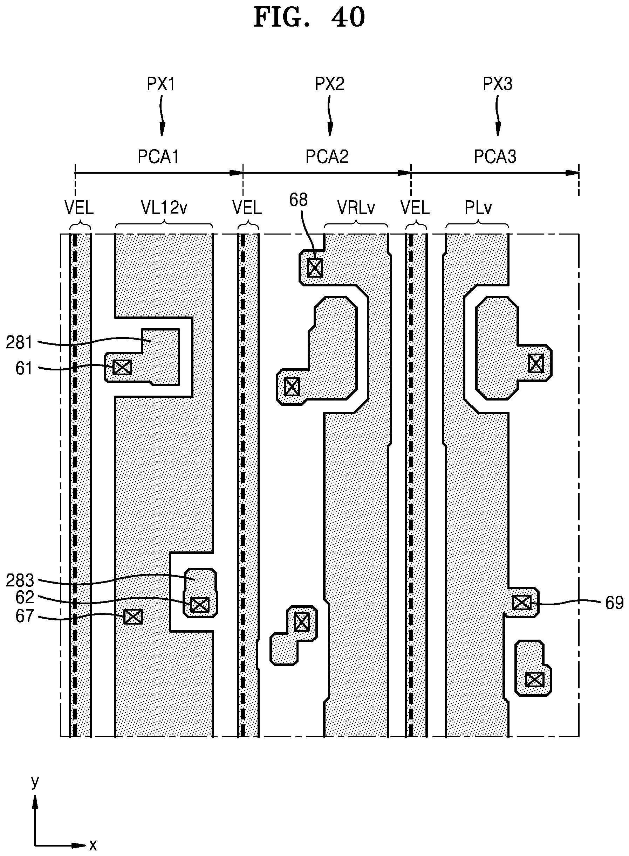

Referring to FIG. 40, a fourth insulating layer 104 may be disposed over the third insulating layer 103 to cover the third conductive layer, and a fourth conductive layer may be disposed over the fourth insulating layer 104. The fourth conductive layer may include a plurality of vertical conductive lines VVL (see FIGS. 13 to 15) and connection electrodes 281 and 283. FIG. 40 illustrates an example in which the first vertical conductive line VVL1 is the second vertical initialization voltage line VL12v, the second vertical conductive line VVL2 is the vertical reference voltage line VRLv, and the third vertical conductive line VVL3 is the vertical driving voltage line PLv.

The second vertical initialization voltage line VL12v may be connected to the connection electrode 278 arranged in the first circuit area PCA1, through a contact hole 67 passing through the fourth insulating layer 104. Because the connection electrode 278 is connected to the source area S4 of the fourth transistor T4 and the source area S4 of the fourth transistor T4 is connected to the 1st-2 initialization voltage line VL12, the second vertical initialization voltage line VL12v may be electrically connected to the 1st-2 initialization voltage line VL12.

The vertical reference voltage line VRLv may be connected to the connection electrode 272 arranged in the second circuit area PCA2, through a contact hole 68 passing through the fourth insulating layer 104. Because the connection electrode 272 is connected to the reference voltage line VRL, the vertical reference voltage line VRLv may be electrically connected to the reference voltage line VRL.

The vertical driving voltage line PLv may be connected to the connection electrode 274 arranged in the third circuit area PCA3, through a contact hole 69 passing through the fourth insulating layer 104. Because the connection electrode 274 is connected to the conductive line 200, the vertical driving voltage line PLv may be electrically connected to the driving voltage line PL.

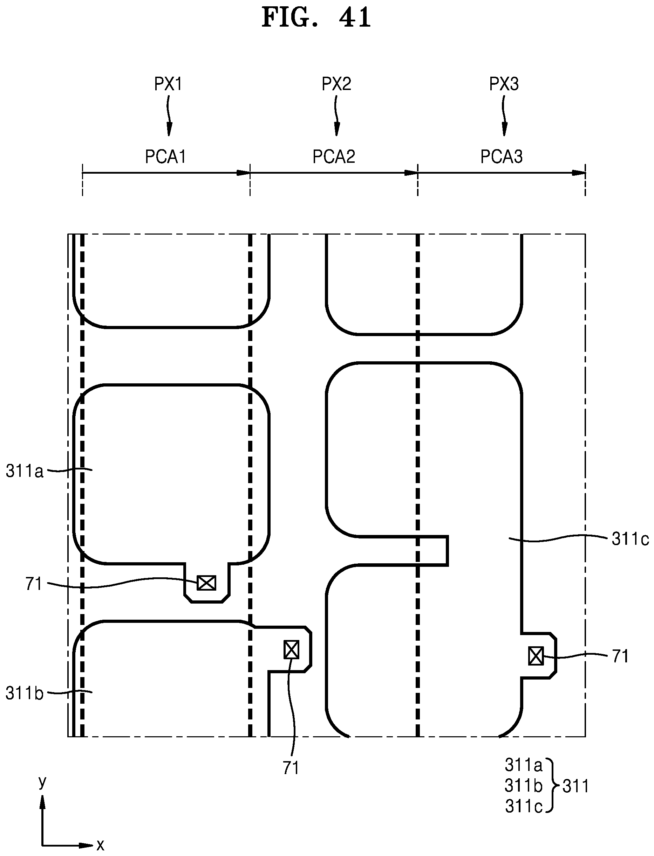

Referring to FIG. 41, a fifth insulating layer 105 may be disposed over the fourth insulating layer 104 to cover the fourth conductive layer, and an organic light-emitting diode OLED may be disposed as a display element over the fifth insulating layer 105. The organic light-emitting diode OLED may include a pixel electrode 311, an opposite electrode 315, and an intermediate layer between the pixel electrode 311 and the opposite electrode 315.

FIG. 43 is a diagram illustrating the arrangement of a data line and a signal line according to a comparative example. In the comparative example, the conductive line 200, which is the driving voltage line PL, may be disposed under the data line DL to overlap the data line DL in a plan view, the shielding line VEL may be disposed over the data line DL to overlap the data line DL in a plan view, and the vertical driving voltage line PLv may be disposed over the connection electrode 270 to overlap the connection electrode 270 in a plan view.

In the comparative example, a capacitor C' may be formed between the data line DL and the driving voltage line PL (the conductive line 200) to which the first driving voltage ELVDD is supplied. When the data signal DATA changes, the first driving voltage ELVDD supplied to the driving voltage line PL may change (rise or fall) instantaneously due to the coupling of the capacitor C'. The voltage of the second terminal of the first transistor T1, that is, the voltage of the second node N2, may change due to a change in the first driving voltage ELVDD due to the coupling of a capacitor formed between the vertical driving voltage line PLv and the connection electrode 270, which may change the gate-source voltage of the first transistor T1.

In an embodiment, in the circuit area in which at least one of the first pixel PX1, the second pixel PX2, and the third pixel PX3 in a unit pixel is arranged, the vertical driving voltage line PLv may not be disposed over the connection electrode 270. In an embodiment, the vertical driving voltage line PLv may not be arranged in the second circuit area PCA2 in which a pixel with a great brightness contribution in the unit pixel, for example, the second pixel PX2 that is a green pixel, is arranged, thereby minimizing the capacitance of a capacitor formed between the vertical driving voltage line PLv and the connection electrode 270.

The pixel circuit of the pixel according to embodiments is not limited to the pixel circuit illustrated in FIG. 33. In other embodiments, the disclosure may be applied to various pixel circuits including a first capacitor C1 and a second capacitor C2 connected to the second terminal (source) of the first transistor T1.

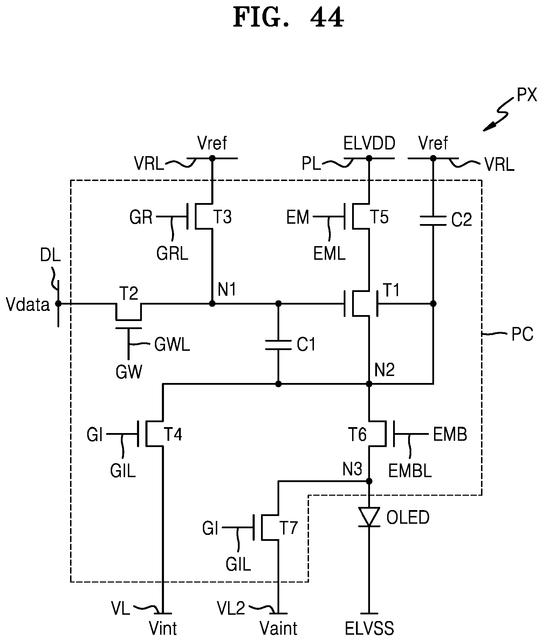

FIGS. 44 to 49 illustrate equivalent circuits of a pixel according to embodiments.

The pixel circuit PC of the pixel PX of FIG. 44 may be different from the pixel circuit PC of FIG. 33 in that the fourth transistor T4 is connected to the second node N2 and the initialization voltage line VL and a seventh transistor T7 is additionally connected to the third node N3 and a second initialization voltage line VL2. The fourth transistor T4 may be turned on by the second gate signal GI received from the second gate line GIL, to transmit the initialization voltage Vint received from the initialization voltage line VL, to the second node N2. The second initialization voltage line VL2 may be provided separately from the initialization voltage line VL and may be configured to supply a second initialization voltage Vaint that is different from the initialization voltage Vint. In an embodiment, the second initialization voltage Vaint may have a higher voltage level than the initialization voltage Vint. The seventh transistor T7 may be turned on by the second gate signal GI received through the second gate line GIL, to transmit the second initialization voltage Vaint received through the second initialization voltage line VL2, to the third node N3. The second node N2 and the third node N3 may be initialized to different voltages by the fourth transistor T4 and the seventh transistor T7, respectively.

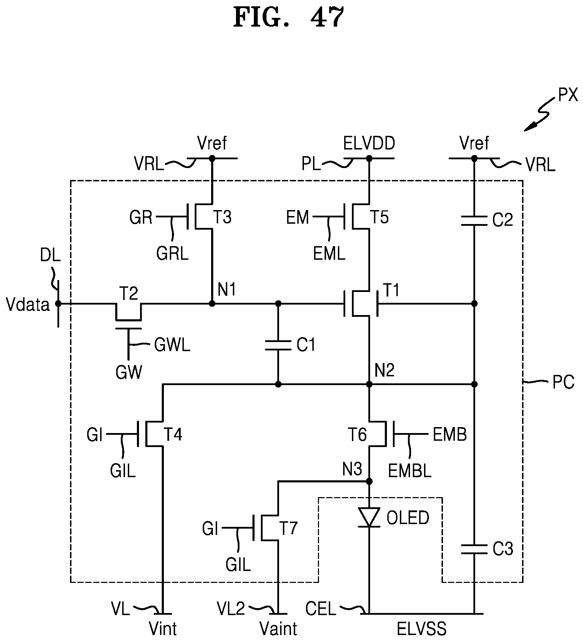

In an embodiment, as illustrated in FIG. 47, a third capacitor C3 may be added to the pixel circuit PC of the pixel PX illustrated in FIG. 44. The third capacitor C3 may be connected between the second node N2 and a common voltage line CEL.

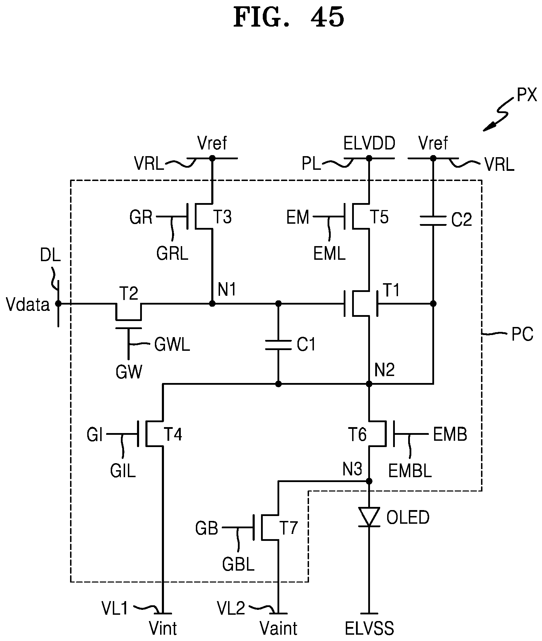

The pixel circuit PC of the pixel PX of FIG. 45 may be different from the pixel circuit PC of FIG. 44 in that the gate of the seventh transistor T7 is connected to a sixth gate line GBL to receive a sixth gate signal GB. The fourth transistor T4 and the seventh transistor T7 may be connected to different gate lines and controlled by different gate signals to independently control the initialization timing of the second node N2 and the third node N3.

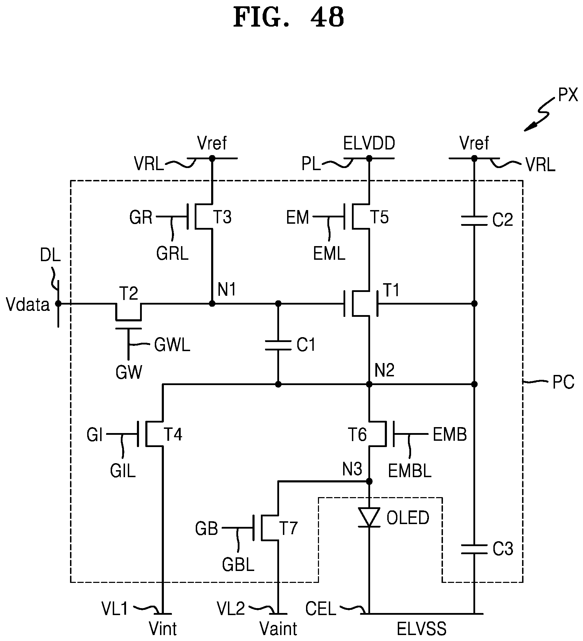

In an embodiment, as illustrated in FIG. 48, a third capacitor C3 may be added to the pixel circuit PC of the pixel PX illustrated in FIG. 45. The third capacitor C3 may be connected between the second node N2 and a common voltage line CEL.

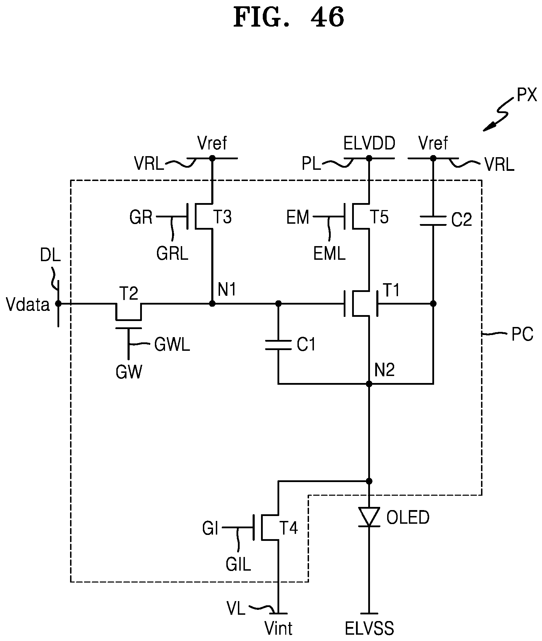

The pixel circuit PC of the pixel PX of FIG. 46 may be different from the pixel circuit PC of the pixel PX of FIG. 33 in that the sixth transistor T6 is omitted.

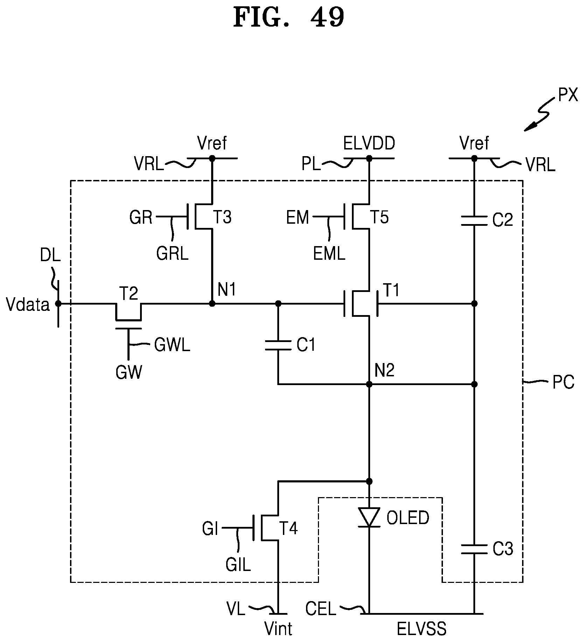

In an embodiment, as illustrated in FIG. 49, a third capacitor C3 may be added to the pixel circuit PC of the pixel PX illustrated in FIG. 46. The third capacitor C3 may be connected between the second node N2 and a common voltage line CEL.

In the above embodiments, the pixel circuit PC may include N-type transistors; however, embodiments are not limited thereto. For example, according to various embodiments, a plurality of transistors of the pixel circuit PC may be P-type transistors, or some may be P-type transistors and others may be N-type transistors. In an embodiment, a driving transistor among the plurality of transistors of the pixel circuit PC may be an N-type transistor, and at least one of the other transistors may be a P-type transistor. The P-type transistor may be a low-temperature polysilicon ("LTPS") thin film transistor including a semiconductor layer including polysilicon.

According to embodiments, in a pixel where a capacitor is connected between an electrode (e.g., source) of a driving transistor and a signal line (e.g., the driving voltage line PL or the reference voltage line VRL) configured to supply a constant voltage to the pixel, a shielding line may be disposed over and/or under the data line DL. Accordingly, by minimizing (e.g., preventing) the formation of a capacitor between the data line DL and the signal line, when the data signal DATA changes, a change in the gate-source voltage of the driving transistor T1 may not be caused due to the coupling of a capacitor formed between the data line DL and the signal line. Because the shielding line is not electrically connected to the pixel, the shielding voltage supplied to the shielding line may be one of the constant voltages supplied to the pixel as well as the constant voltage not supplied to the pixel.

Also, according to embodiments, a signal line to which a first driving voltage is supplied may not be arranged over an electrode (e.g., source) of the driving transistor in at least one of subpixels (e.g., a red pixel, a green pixel, and a blue pixel) in the unit pixel. Accordingly, when the data signal changes, a change in the gate-source voltage of the driving transistor may not be caused due to the coupling of a capacitor formed between an electrode (e.g., source) of the driving transistor and a signal line to which a driving voltage is supplied.

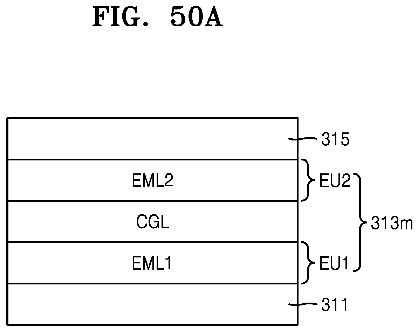

FIGS. 50A to 51B are cross-sectional views illustrating the structure of a display element according to embodiments.

An organic light-emitting diode OLED as a display element according to an embodiment may include a pixel electrode 311, an opposite electrode 315, and an intermediate layer 313m between the pixel electrode 311 (a first electrode or an anode) and the opposite electrode 315 (a second electrode or a cathode).

The pixel electrode 311 may include a transparent conductive oxide such as indium tin oxide ("ITO"), indium zinc oxide ("IZO"), zinc oxide (ZnO), indium oxide (In₂O₃), indium gallium oxide ("IGO"), or aluminum zinc oxide ("AZO"). The pixel electrode 311 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. For example, the pixel electrode 311 may have a three-layer structure of ITO/Ag/ITO.

The opposite electrode 315 may be disposed over the intermediate layer 313m. The opposite electrode 315 may include a metal with a low work function, an alloy, an electrically conductive compound, or any combination thereof. For example, the opposite electrode 315 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The opposite electrode 315 may be a transparent electrode, a semitransparent electrode, or a reflective electrode.

The intermediate layer 313m may include a high-molecular weight or low-molecular weight organic material for emitting light of a certain color. In addition to various organic materials, the intermediate layer 313m may further include a metal-containing compound such as an organometallic compound, or an inorganic material such as a quantum dot.

In an embodiment, the intermediate layer 313m may include an emission layer and a first functional layer and a second functional layer under and over the emission layer respectively. For example, the first functional layer may include a hole transport layer (HTL) or may include an HTL and a hole injection layer (HIL). The second functional layer may include an electron transport layer (ETL) and/or an electron injection layer (EIL). The first functional layer or the second functional layer may be omitted. The first functional layer and the second functional layer may be integrally formed to correspond to a plurality of organic light-emitting diodes OLED included in the display area DA.

In an embodiment, the intermediate layer 313m may include two or more emission units sequentially stacked between the pixel electrode 311 and the opposite electrode 315 and a charge generation layer CGL arranged between two emission units. When the intermediate layer 313m includes an emission unit and a charge generation layer, the organic light-emitting diode OLED may be a tandem light emitting device. Because the organic light-emitting diode OLED has a stack structure of a plurality of emission units, the color purity and the light emission efficiency thereof may be improved.

One emission unit may include an emission layer and a first functional layer and a second functional layer under and over the emission layer respectively. The charge generation layer CGL may include a negative charge generation layer and a positive charge generation layer. The light emission efficiency of the organic light-emitting diode OLED that is a tandem light emitting device including a plurality of emission layers may be further improved by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

In an embodiment, as illustrated in FIG. 50A, the organic light-emitting diode OLED may include a first emission unit EU1 including a first emission layer EML1 and a second emission unit EU2 including a second emission layer EML2, which are sequentially stacked. The charge generation layer CGL may be provided between the first emission unit EU1 and the second emission unit EU2. For example, the organic light-emitting diode OLED may include a pixel electrode 311, a first emission layer EML1, a charge generation layer CGL, a second emission layer EML2, and an opposite electrode 315 that are sequentially stacked. A first functional layer and a second functional layer may be included under and over the first emission layer EML1 respectively. A first functional layer and a second functional layer may be included under and over the second emission layer EML2 respectively. The first emission layer EML1 may be a blue emission layer, and the second emission layer EML2 may be a yellow emission layer.

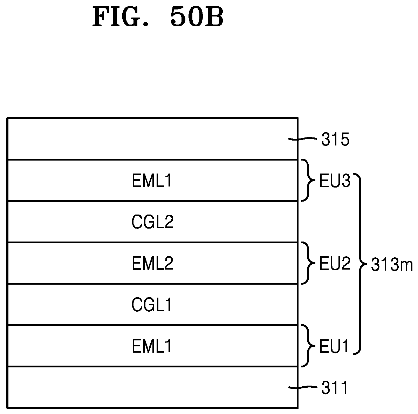

In an embodiment, as illustrated in FIG. 50B, the organic light-emitting diode OLED may include a first emission unit EU1 and a third emission unit EU3 each including a first emission layer EML1 and a second emission unit EU2 including a second emission layer EML2. A first charge generation layer CGL1 may be provided between the first emission unit EU1 and the second emission unit EU2, and a second charge generation layer CGL2 may be provided between the second emission unit EU2 and the third emission unit EU3. For example, the organic light-emitting diode OLED may include a pixel electrode 311, a first emission layer EML1, a first charge generation layer CGL1, a second emission layer EML2, a second charge generation layer CGL2, a first emission layer EML1, and an opposite electrode 315 that are sequentially stacked. A first functional layer and a second functional layer may be included under and over the first emission layer EML1 respectively. A first functional layer and a second functional layer may be included under and over the second emission layer EML2 respectively. The first emission layer EML1 may be a blue emission layer, and the second emission layer EML2 may be a yellow emission layer.

In an embodiment, in the organic light-emitting diode OLED, in addition to the second emission layer EML2, the second emission unit EU2 may further include a third emission layer EML3 and/or a fourth emission layer EML4 directly contacting under and/or over the second emission layer EML2. Here, directly contacting may mean that no other layer is arranged between the second emission layer EML2 and the third emission layer EML3 and/or between the second emission layer EML2 and the fourth emission layer EML4. The third emission layer EML3 may be a red emission layer, and the fourth emission layer EML4 may be a green emission layer.

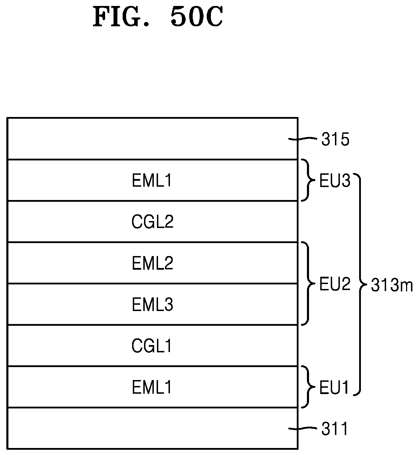

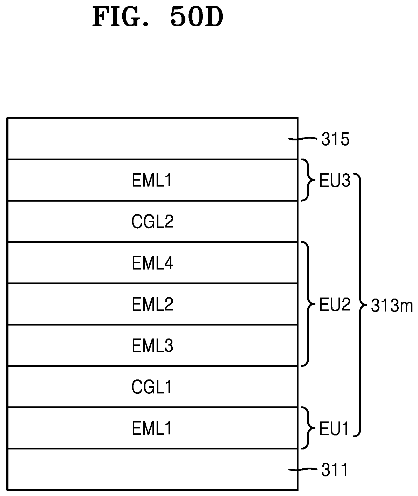

For example, as illustrated in FIG. 50C, the organic light-emitting diode OLED may include a pixel electrode 311, a first emission layer EML1, a first charge generation layer CGL1, a third emission layer EML3, a second emission layer EML2, a second charge generation layer CGL2, a first emission layer EML1, and an opposite electrode 315 that are sequentially stacked. Alternatively, as illustrated in FIG. 50D, the organic light-emitting diode OLED may include a pixel electrode 311, a first emission layer EML1, a first charge generation layer CGL1, a third emission layer EML3, a second emission layer EML2, a fourth emission layer EML4, a second charge generation layer CGL2, a first emission layer EML1, and an opposite electrode 315 that are sequentially stacked.

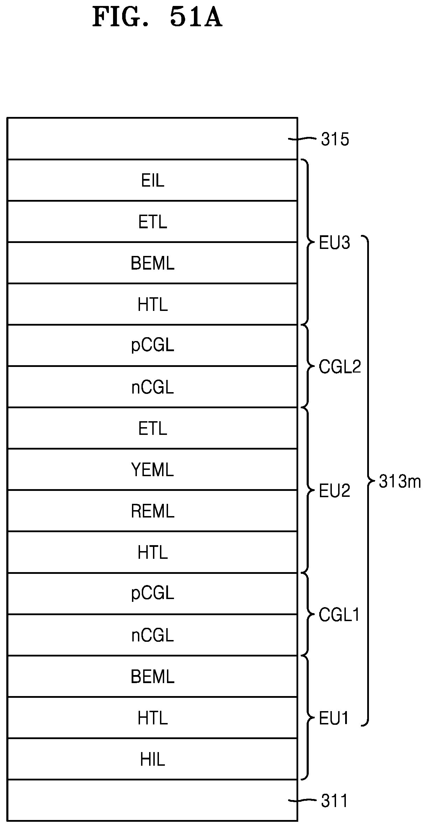

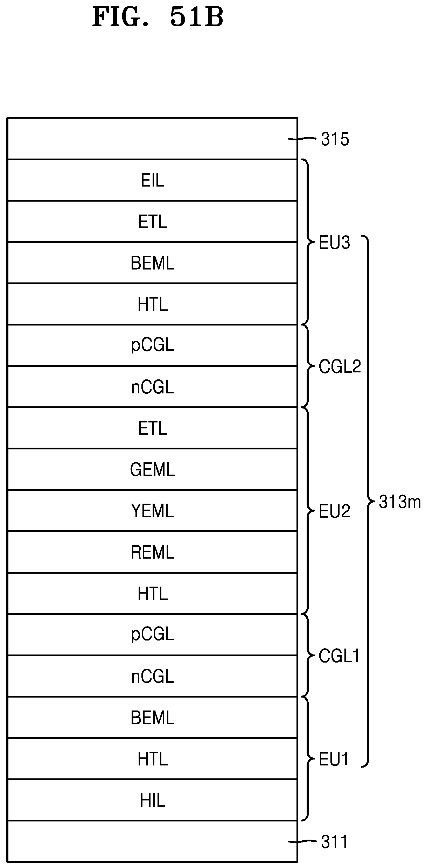

FIG. 51A is a cross-sectional view illustrating an example of the organic light-emitting diode of FIG. 50C, and FIG. 51B is a cross-sectional view illustrating an example of the organic light-emitting diode of FIG. 50D.

Referring to FIG. 51A, the organic light-emitting diode OLED may include a first emission unit EU1, a second emission unit EU2, and a third emission unit EU3 that are sequentially stacked. A first charge generation layer CGL1 may be provided between the first emission unit EU1 and the second emission unit EU2, and a second charge generation layer CGL2 may be provided between the second emission unit EU2 and the third emission unit EU3. Each of the first charge generation layer CGL1 and the second charge generation layer CGL2 may include a negative charge generation layer nCGL and a positive charge generation layer pCGL.

The first emission unit EU1 may include a blue emission layer BEML. The first emission unit EU1 may further include a hole injection layer HIL and a hole transport layer HTL between the pixel electrode 311 and the blue emission layer BEML. In an embodiment, a p-doped layer may be further included between the hole injection layer HIL and the hole transport layer HTL. The p-doped layer may be formed by doping the hole injection layer HIL with a p-type dopant. In an embodiment, at least one of a blue light auxiliary layer, an electron blocking layer, and a buffer layer may be further included between the blue emission layer BEML and the hole transport layer HTL. The blue light auxiliary layer may increase the light output efficiency of the blue emission layer BEML. The blue light auxiliary layer may adjust the hole charge balance to increase the light output efficiency of the blue emission layer BEML. The electron blocking layer may prevent the injection of electrons into the hole transport layer HTL. The buffer layer may compensate for the resonance distance depending on the wavelength of light emitted from the emission layer.

The second emission unit EU2 may include a yellow emission layer YEML and a red emission layer REML directly contacting the yellow emission layer YEML under the yellow emission layer YEML. The second emission unit EU2 may further include a hole transport layer HTL between the red emission layer REML and the positive charge generation layer pCGL of the first charge generation layer CGL1 and may further include an electron transport layer ETL between the yellow emission layer YEML and the negative charge generation layer nCGL of the second charge generation layer CGL2.

The third emission unit EU3 may include a blue emission layer BEML. The third emission unit EU3 may further include a hole transport layer HTL between the blue emission layer BEML and the positive charge generation layer pCGL of the second charge generation layer CGL2. The third emission unit EU3 may further include an electron transport layer ETL and an electron injection layer EIL between the blue emission layer BEML and the opposite electrode 315. The electron transport layer ETL may include a single layer or multiple layers. In an embodiment, at least one of a blue light auxiliary layer, an electron blocking layer, and a buffer layer may be further included between the blue emission layer BEML and the hole transport layer HTL. At least one of a hole blocking layer and a buffer layer may be further included between the blue emission layer BEML and the electron transport layer ETL. The hole blocking layer may prevent the injection of holes into the electron transport layer ETL.

The organic light-emitting diode OLED illustrated in FIG. 51B may be different from the organic light-emitting diode OLED illustrated in FIG. 51A in terms of the stack structure of the second emission unit EU2, and other configurations thereof may be the same as those illustrated in FIG. 51A. Referring to FIG. 51B, the second emission unit EU2 may include a yellow emission layer YEML, a red emission layer REML directly contacting the yellow emission layer YEML under the yellow emission layer YEML, and a green emission layer GEML directly contacting the yellow emission layer YEML over the yellow emission layer YEML. The second emission unit EU2 may further include a hole transport layer HTL between the red emission layer REML and the positive charge generation layer pCGL of the first charge generation layer CGL1 and may further include an electron transport layer ETL between the green emission layer GEML and the negative charge generation layer nCGL of the second charge generation layer CGL2.

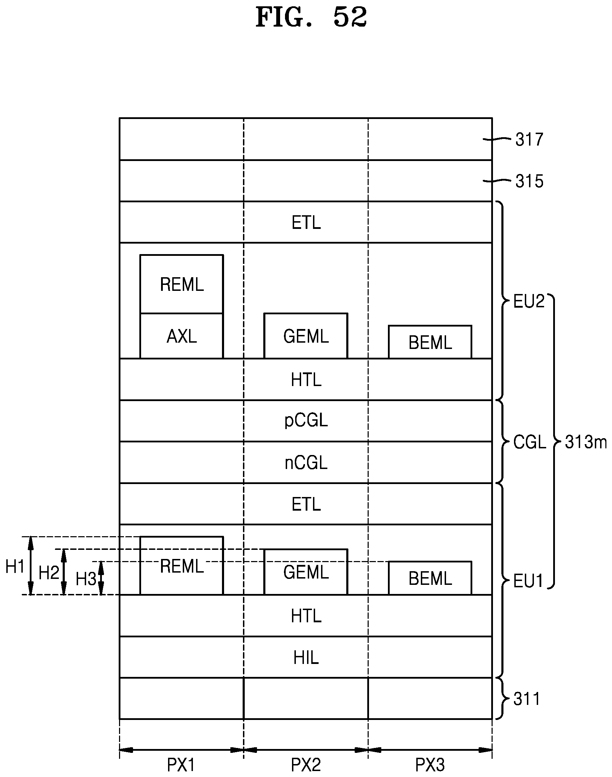

FIG. 52 is a cross-sectional view illustrating the structure of a pixel of a display apparatus according to an embodiment.

Referring to FIG. 52, the display apparatus may include a plurality of pixels. The plurality of pixels may include a first pixel PX1, a second pixel PX2, and a third pixel PX3. Each of the first pixel PX1, the second pixel PX2, and the third pixel PX3 may include a pixel electrode 311, an opposite electrode 315, and an intermediate layer 313m. In an embodiment, the first pixel PX1 may be a red pixel, the second pixel PX2 may be a green pixel, and the third pixel PX3 may be a blue pixel. Here, each pixel may include an organic light-emitting diode OLED as a display element, and the organic light-emitting diode OLED of each pixel may be electrically connected to a pixel circuit.

The pixel electrode 311 may be independently provided in each of the first pixel PX1, the second pixel PX2, and the third pixel PX3.

The intermediate layer 313m of the organic light-emitting diode OLED of each of the first pixel PX1, the second pixel PX2, and the third pixel PX3 may include a first emission unit EU1 and a second emission unit EU2, which are sequentially stacked, and a charge generation layer CGL between the first emission unit EU1 and the second emission unit EU2. The charge generation layer CGL may include a negative charge generation layer nCGL and a positive charge generation layer pCGL. The charge generation layer CGL may be a common layer continuously formed in the first pixel PX1, the second pixel PX2, and the third pixel PX3.

The first emission unit EU1 of the first pixel PX1 may include a hole injection layer HIL, a hole transport layer HTL, a red emission layer REML, and an electron transport layer ETL that are sequentially stacked over the pixel electrode 3111. The first emission unit EU1 of the second pixel PX2 may include a hole injection layer HIL, a hole transport layer HTL, a green emission layer GEML, and an electron transport layer ETL that are sequentially stacked over the pixel electrode 311. The first emission unit EU1 of the third pixel PX3 may include a hole injection layer HIL, a hole transport layer HTL, a blue emission layer BEML, and an electron transport layer ETL that are sequentially stacked over the pixel electrode 311. Each of the hole injection layer HIL, the hole transport layer HTL, and the electron transport layer ETL of the first emission units EU1 may be a common layer continuously formed in the first pixel PX1, the second pixel PX2, and the third pixel PX3.

The second emission unit EU2 of the first pixel PX1 may include a hole transport layer HTL, an auxiliary layer AXL, a red emission layer REML, and an electron transport layer ETL that are sequentially stacked over the charge generation layer CGL. The second emission unit EU2 of the second pixel PX2 may include a hole transport layer HTL, a green emission layer GEML, and an electron transport layer ETL that are sequentially stacked over the charge generation layer CGL. The second emission unit EU2 of the third pixel PX3 may include a hole transport layer HTL, a blue emission layer BEML, and an electron transport layer ETL that are sequentially stacked over the charge generation layer CGL. Each of the hole transport layer HTL and the electron transport layer ETL of the second emission units EU2 may be a common layer continuously formed in the first pixel PX1, the second pixel PX2, and the third pixel PX3. In an embodiment, at least one of a hole blocking layer and a buffer layer may be further included between the emission layer and the electron transport layer ETL in the second emission unit EU2 of the first pixel PX1, the second pixel PX2, and the third pixel PX3.

A thickness H1 of the red emission layer REML, a thickness H2 of the green emission layer GEML, and a thickness H3 of the blue emission layer BEML may be determined according to the resonance distance. The auxiliary layer AXL may be a layer added to adjust the resonance distance and may include a resonance auxiliary material. For example, the auxiliary layer AXL may include the same material as the hole transport layer HTL.

In FIG. 52, the auxiliary layer AXL is included only in the first pixel PX1; however, embodiments are not limited thereto. For example, the auxiliary layer AXL may be included in at least one of the first pixel PX1, the second pixel PX2, and the third pixel PX3 to adjust the resonance distance of each of the first pixel PX1, the second pixel PX2, and the third pixel PX3.

The display apparatus may further include a capping layer 317 arranged outside the opposite electrode 315. The capping layer 317 may improve the light emission efficiency according to the principle of constructive interference. Accordingly, the light extraction efficiency of the organic light-emitting diode OLED may be increased, and thus, the light emission efficiency of the organic light-emitting diode OLED may be improved.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A display apparatus comprising:
a data line connected to a pixel arranged in a display area, wherein the data line extends in a first direction;
a shielding line disposed over the data line in the display area, extending in the first direction, and overlapping the data line in a plan view; and
a first voltage line connected to the pixel, extending in a second direction perpendicular to the first direction, disposed under the data line, and overlapping the data line in the plan view.

2. The display apparatus of claim 1, wherein the pixel comprises:
a first capacitor comprising a first electrode and a second electrode disposed over the first electrode and overlapping the first electrode in the plan view;
a first transistor connected to the first voltage line and the second electrode of the first capacitor; and
a second transistor connected to the data line and a gate electrode of the first transistor,
wherein the data line is arranged in a same layer as the second electrode of the first capacitor, and
a semiconductor layer of the first transistor is arranged in a same layer as the first electrode of the first capacitor.

3. The display apparatus of claim 2, wherein a voltage supplied to the shielding line and a voltage supplied to the first electrode of the first capacitor are different from each other.

4. The display apparatus of claim 2, wherein a voltage supplied to the shielding line and a voltage supplied to the first electrode of the first capacitor are equal to each other.

5. The display apparatus of claim 2, wherein the first capacitor further comprises a third electrode disposed under the first electrode, overlapping the first electrode in the plan view, and connected to the second electrode.

6. The display apparatus of claim 5, wherein the first voltage line is arranged in a same layer as the third electrode of the first capacitor and connected to the first electrode of the first capacitor.

7. The display apparatus of claim 6, further comprising a vertical conductive line arranged in a same layer as the shielding line, overlapping the second electrode of the first capacitor in the plan view, and extending in the first direction.

8. The display apparatus of claim 7, wherein the vertical conductive line is configured to supply a constant voltage to the pixel and connected to a horizontal conductive line extending in the second direction.

9. The display apparatus of claim 8, wherein the horizontal conductive line comprises the first voltage line.

10. The display apparatus of claim 5, wherein the pixel further comprises a
second capacitor connected to the second electrode of the first capacitor and a light emitting element,
wherein the light emitting element comprises a first electrode connected to the first transistor and a second electrode facing the first electrode, and the second capacitor is connected to the second electrode of the light emitting element.

11. The display apparatus of claim 5, further comprising a second voltage line extending in the second direction and connected to the first electrode of the first capacitor.

12. The display apparatus of claim 11, further comprising a vertical conductive line arranged in a same layer as the shielding line, overlapping the first electrode of the first capacitor in the plan view, and extending in the first direction.

13. The display apparatus of claim 12, wherein the vertical conductive line is configured to supply a constant voltage to the pixel and connected to a horizontal conductive line extending in the second direction.

14. The display apparatus of claim 13, wherein the horizontal conductive line comprises the second voltage line.

15. The display apparatus of claim 1, further comprising a voltage supply line arranged in a non-display area outside the display area, connected to the shielding line, and configured to supply a shielding voltage to the shielding line.

16. A display apparatus comprising:
a first pixel circuit arranged in a first circuit area; and
a second pixel circuit arranged in a second circuit area adjacent to the first circuit area in a first direction,
wherein each of the first pixel circuit and the second pixel circuit is connected to a light-emitting diode, and
each of the first pixel circuit and the second pixel circuit comprises:
a data line extending in a second direction perpendicular to the first direction;
a shielding line disposed over the data line, extending in the second direction, and overlapping the data line in a plan view;
a first voltage line extending in the first direction, disposed under the data line, and partially overlapping the data line in the plan view;
a capacitor comprising a first electrode and a second electrode disposed over the first electrode and overlapping the first electrode in the plan view;
a first transistor connected to the first voltage line and the second electrode of the capacitor;
a second transistor connected to the data line and a gate electrode of the first transistor;
a third transistor connected to the gate electrode of the first transistor and a second voltage line extending in the first direction;
a fourth transistor connected to a first electrode of the light-emitting diode and a third voltage line extending in the first direction; and
a conductive line arranged in a same layer as the shielding line, overlapping the second electrode of the capacitor in the plan view, and extending in the second direction,
wherein the light-emitting diode connected to the first pixel circuit emits light in a first color,
the light-emitting diode connected to the second pixel circuit emits light in a second color,
the conductive line of the first pixel circuit is connected to one of the first voltage line, the second voltage line, the third voltage line, and a fourth voltage line connected to a second electrode of the light-emitting diode, and
the conductive line of the second pixel circuit is connected to one of the second voltage line, the third voltage line, and the fourth voltage line, excluding the first voltage line.

17. The display apparatus of claim 16, wherein a voltage supplied to the shielding line and a voltage supplied to the first electrode of the capacitor are different from each other.

18. The display apparatus of claim 16, wherein a voltage supplied to the shielding line and a voltage supplied to the first electrode of the capacitor are equal to each other.

19. The display apparatus of claim 16, wherein the capacitor further comprises a third electrode disposed under the first electrode, overlapping the first electrode in the plan view, and connected to the second electrode.

20. The display apparatus of claim 19, wherein the first voltage line is arranged in a same layer as the third electrode of the capacitor and connected to the first electrode of the capacitor.

21. The display apparatus of claim 19, wherein the second voltage line is arranged in a same layer as the third electrode of the capacitor and connected to the first electrode of the capacitor.
